(19) Europäisches Patentamt

European Patent Office

Office européen des brevets

(11) **EP 4 250 090 A1**

(12) **EUROPEAN PATENT APPLICATION**

(43) Date of publication:
**27.09.2023 Bulletin 2023/39**

(21) Application number: **23163966.7**

(22) Date of filing: **24.03.2023**

(51) International Patent Classification (IPC):
**G06F 7/483** (2006.01)       **H03M 7/24** (2006.01)

(52) Cooperative Patent Classification (CPC):
**G06F 7/483; H03M 7/24**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.03.2022 CN 202210296644**

(71) Applicant: **Huawei Technologies Co., Ltd.**
**Shenzhen, Guangdong 518129 (CN)**

(72) Inventors:
• **LUO, Yuanyong**
  **Shenzhen, 518129 (CN)**
• **WU, Wei Hsiang**
  **SHENZHEN, 518129 (CN)**
• **ZHANG, Zhongxing**
  **SHENZHEN, 518129 (CN)**

(74) Representative: **Körber, Martin Hans**
**Mitscherlich PartmbB**
**Patent- und Rechtsanwälte**
**Karlstraße 7**
**80333 München (DE)**

(54) **METHOD FOR PROCESSING FLOATING POINT NUMBER AND RELATED DEVICE**

(57) Embodiments of this application disclose a method for processing a floating point number and a related device, which may be used in the fields of general-purpose computing, high performance computing, artificial intelligence training and inference, and the like. The method includes: obtaining a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; and obtaining normalized data corresponding to the first floating point number based on the first sign field, the exponent bit width field, the first exponent field, and the first mantissa field. In this application, an exponent bit width field for indicating a bit width of an exponent field is additionally defined in a conventional floating point number, so that the bit width of the exponent field and the bit width of the subsequent mantissa field may dynamically change with a value of the exponent bit width field to meet requirements for different numerical ranges and precision of floating point numbers in different scenarios. Embodiments of this application may optimize a floating point number format and improve use effect of a floating point number.

| HiFloat (floating point) decoder (decoder) [100] | | | |
|---|---|---|---|
| Sign (sign): 1 bit | Dot: DW bits (D) | Exponent (exponent): D bits | Mantissa (mantissa): (N–1–DW–D) bits |
| S | | {E,M}=MUX (D) | |

Computing unit [400]

FIG. 2

EP 4 250 090 A1

**Description**

**TECHNICAL FIELD**

This application relates to the field of computer technologies, and in particular, to a method for processing a floating point number and a related device.

**BACKGROUND**

The institute of electrical and electronics engineers (institute of electrical and electronics engineers, IEEE) 754 binary floating point number arithmetic standard defines floating point data representation methods, such as double-precision floating point (floating point, FP) 64 and single-precision FP32, which are widely used by central processing units (central processing unit, CPU) and floating point operators. The standard also defines a half-precision FP16 floating point data representation method suitable for use in computer graphics environments. An IEEE 754 floating point number includes three fields: a sign (sign) field, an exponent (exponent) field, and a mantissa (mantissa) field. In a floating point data representation method of each precision, a bit width of each field is fixed. For example, an FP16 includes a 1-bit (bit) sign field, a 5-bit exponent field, and a 10-bit mantissa field. For example, an FP32 includes a 1-bit sign field, an 8-bit exponent field, and a 23-bit mantissa field. For example, an FP64 includes a 1-bit sign field, an 11-bit exponent field, and a 52-bit mantissa field. The bit width of the exponent field determines a numerical range that can be represented by a floating point number, and the bit width of the mantissa field determines a value precision that can be represented by the floating point number.

With rapid development of artificial intelligence (artificial intelligence, AI) mixed precision training, computing resources in low-precision floating point data formats start to be deployed on a large scale, for example, an FP16+FP32 mixed training mode and a brain floating-point (brain floating-point, BF) 16+FP32 mixed training mode that have been commercially successful. Nowadays, various 8-bit floating point data formats, such as FP8-shared exponent bias (shared exponent bias, SEB), mixed floating point (mixed floating point, HFP) 8, and configurable floating point (configurable floating point, CFP) 8, are put forward in the academic and industry.

At the same time, conventional high performance computing (high performance computing, HPC) applications that require high precision are also intended to use low-precision computing power that has been deployed on a large scale. Therefore, many mixed-precision solver algorithms are developed. These algorithms first use low-precision computing power, such as FP16/BF16, to obtain a low-precision initial computing result, and then use an iterative algorithm and a high-precision data format FP32/FP64 to obtain a high-precision computing result.

However, for AI mixed precision training, an existing floating point data format or a numerical range, which is not large enough, often involves a large quantity of scaling (scaling) operations; or low precision affects a convergence speed and a final function; or an excessive bit width causes excessive data storage and data transfer overheads.

Similarly, for the field of HPC, increasing applications no longer require high-precision data formats such as FP64. However, the precision of FP32 is slightly strained for some HPC applications.

**SUMMARY**

Embodiments of this application provide a method for processing a floating point number and a related device, which can improve the performance of a floating point number.

The method for processing a floating point number, provided in embodiments of this application, may be performed by an electronic device or the like. The electronic device is a device that can be abstracted as a computer system. The electronic device that supports a floating point number processing function may also be referred to as an apparatus for processing a floating point number. The apparatus for processing a floating point number may be the entire electronic device, for example, an intelligent wearable device, a smartphone, a tablet computer, a notebook computer, a desktop computer, an in-vehicle computer, or a server; or may be a system/apparatus including a plurality of entire devices, for example, a server cluster or a cloud computing service center including a plurality of servers; or may be some components in the electronic device, for example, a processor and a chip related to floating point number processing, such as a system on a chip (system on a chip, SoC). Optionally, the processor and the chip may be integrated with an encoder, a decoder, and the like that code/decode a floating point number. This is not specifically limited in this embodiment of this application. The system on a chip is also referred to as a system on chip.

According to a first aspect, an embodiment of this application provides a method for processing a floating point number, including: obtaining a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; and obtaining normalized data corresponding to the first floating point number based on the first sign field, the exponent bit width field, the first exponent field, and the first mantissa field, where the normalized data includes a second sign field, a second exponent field, and a second mantissa field in a scientific notation method.

A conventional floating point number includes a sign field, an exponent field, and a mantissa field. When a total bit width of the floating point number is definite, bit widths of the exponent field and the mantissa field of the floating point number are always fixed. For example, a bit width of an exponent field of an FP16 is 5 bits, and a bit width of a mantissa field of the FP16 is 10 bits. For another example, a bit width of an exponent field of an FP32 is 8 bits, and a bit width of a mantissa field of the FP32 is 23 bits. As a result, only a data format with a larger total bit width (for example, FP64) can be selected when higher precision or a larger numerical range is required for computation. However, this easily causes a waste of a bit width of an exponent field or a bit width of a mantissa field in the FP64, thereby occupying unnecessary storage space, and greatly increasing overheads of data storage and data transfer of a floating point number. In this embodiment of this application, a new floating point data format is provided. In addition to a sign field, an exponent field, and a mantissa field, a Dot field (that is, an exponent bit width field) is additionally defined, and a value of the Dot field is used for indicating a bit width D occupied by the exponent field in a total bit width N of a floating point number, where N is an integer greater than 1, and D is an integer greater than or equal to 0. Therefore, the bit width of the exponent field may dynamically change with a value of the exponent bit width field, and the bit width of the mantissa field in the floating point number also dynamically changes accordingly, thereby meeting requirements for different numerical ranges and precision of floating point numbers in various scenarios. For example, a total bit width of a floating point number is 32 bits, and a Dot field with a bit width of 2 bits is introduced into the floating point number. In this case, a bit width of 29 bits is left in addition to a 1-bit sign field. If a value represented by the Dot field is 2 (that is, a bit width D occupied by the exponent field is 2 bits), a bit width of a mantissa field is 27 bits, which is far greater than a bit width of a mantissa field of 23 bits in the existing FP32. In this embodiment of this application, the bit width of the exponent field is indicated by defining an exponent bit width field, which eliminates a constraint on a fixed bit width of each field in a conventional floating point number, and resolves a problem that it is hard to strike a tradeoff between a numerical range, numerical precision, and a total bit width of the conventional floating point number. In short, this embodiment of this application can flexibly meet different requirements for a numerical range and numerical precision of a floating point number in various scenarios without additionally increasing a total bit width, that is, without increasing data storage or data transfer costs.

In a possible implementation, the first floating point number is used for data storage or data transfer, the normalized data is used for being input to a computing unit to participate in corresponding computation, and the computing unit includes one or more of a scalar computing unit, a vector computing unit, a matrix computing unit, or a tensor computing unit.

In this embodiment of this application, as described above, the exponent bit width field is defined, the floating point data format is optimized, and excessive bit widths are not occupied when requirements of various computations for a numerical range and numerical precision are met, thereby greatly reducing costs of data storage or data transfer of the floating point number. Moreover, a smaller bit width also reduces complexity of coding and decoding of the floating point number, and normalized data corresponding to the floating point number can be obtained more quickly and accurately by decoding (for example, decoding the first exponent field and the first mantissa field in the first floating point number, to obtain a corresponding second exponent field and a corresponding second mantissa field), thereby improving coding and decoding efficiency. Therefore, hardware overheads are reduced, and overall computing efficiency based on the floating point number can be further improved.

In a possible implementation, the obtaining normalized data corresponding to the first floating point number based on the first sign field, the exponent bit width field, the first exponent field, and the first mantissa field includes: obtaining, based on the first sign field, the second sign field in the normalized data; and determining, based on the bit width D indicated by the exponent bit width field, the first exponent field and the first mantissa field from the first floating point number, and obtaining, based on the first exponent field and the first mantissa field, the second exponent field and the second mantissa field in the normalized data.

In this embodiment of this application, an exponent field and a mantissa field (for example, the first exponent field and the first mantissa field in the first floating point number) may be determined quickly and accurately from a floating point number based on a bit width D indicated by an exponent bit width field, to efficiently and accurately obtain normalized data (normal value) corresponding to the floating point number, thereby greatly improving efficiency of decoding the floating point number, and then improving overall computing efficiency based on the floating point number in high performance computing HPC, AI training, or the like.

In a possible implementation, a truth value corresponding to the normalized data satisfies the following formula:

$$X=(-1)^{S}\times 2^{Ei+Ec}\times(1+M)$$

X is a truth value corresponding to the normalized data; S is a value of the second sign field, the value of the second sign field is the same as that of the first sign field, and S is 0 or 1; Ei is a value of the second exponent field; Ec is a preset exponent center; and M is a value of the second mantissa field.

In this embodiment of this application, the sign field of the floating point number generally occupies 1 bit (that is, 1 bit), is used for representing positive or negative, and is located before the exponent bit width field. It should be noted that the value of the sign field in the floating point number is the same as that in the normalized data of the floating point number (for example, the value of the first sign field is the same as that of the second sign field). When the floating point number is decoded to obtain corresponding normalized data, the sign field in the floating point number may be directly inherited, and a value of the sign field is read. Then, based on the read value of the exponent bit width field (that is, the bit width D) in the floating point number, the exponent field and the mantissa field are quickly extracted from the floating point number and decoded, and the normalized data corresponding to the floating point number is obtained afterwards, thereby greatly improving efficiency of decoding the floating point number.

In addition, it should be noted that, a value stored in the mantissa field of the floating point number is a value xxxxx after a decimal point in a mantissa 1.xxxxx, but a value M represented by the value xxxxx is actually 0.Xxxxx. For example, 1.10011 is used as an example. A value of the first mantissa field in the foregoing first floating point number is M'=10011, but a value of the second mantissa field in the normalized data obtained after decoding is M=0.10011, which is not explained and described again.

In a possible implementation, the method further includes: determining, based on the bit width D indicated by the exponent bit width field, a numerical range E corresponding to the first exponent field during coding, where Ei belongs to the numerical range E, and the numerical range E satisfies the following formula:

$$E=(-1)^{Se}\times[2^{D-1}, (2^D-1)]$$

Se is a sign bit of Ei, and Se is 0 or 1. Optionally, Se may also be referred to as an exponent sign bit.

In this embodiment of this application, based on the bit width D indicated by the exponent bit width field, the numerical range corresponding to the exponent field in the floating point number during coding is $E=(-1)^{Se}\times[2^{D-1}, (2^D-1)]$. It can be learned from the formula that, for any Ei within the numerical range E, except the sign bit Se used for representing positive or negative, the most significant bit of the Ei is 1 (that is, the second bit of the Ei is always 1). For example, Se=0, D=3, a numerical range E=[4, 7], and Ei=0100, 0101, 0110, or 0111. For another example, Se=1, D=4, a numerical range E=[8, 15], and Ei=11000, 11001, 11010, 11011, 11100, 11101, 11110, or 11111. Therefore, it can ensure that a value of each bit in the Ei has a practical meaning, and a case in which a smaller value is represented by occupying a redundant bit width, such as 000011, is avoided, so that each bit in the bit width D occupied by the exponent field may not be wasted, more storage space is saved, and data storage or data transfer costs of the floating point number are reduced. Alternatively, when there is a higher requirement for precision, more bit widths may be reserved for the mantissa field without additionally increasing the total bit width, to meet the higher requirement for precision.

In a possible implementation, when D=0, Ei=0; when D is equal to 1, the value of the first exponent field is Es={Se}, and Ei={Se, 1'b1}; or when D is greater than 1, the value of the first exponent field is Es={Se, TF[2:D]}, and Ei={Se, 1'b1, TF[2:D]}, where TF is an amplitude of the Ei, 1'b1 is a most significant bit in the TF, 1'b1 does not occupy a bit width in the first exponent field, and a bit width of the second exponent field is D+1; TF[2:D] represents remaining bits in the TF except the most significant bit 1'b1, and a bit width occupied by the TF[2:D] in the first exponent field and the second exponent field is D-1; and in the Ei, when D is greater than or equal to 1, a next bit of Se is the most significant bit 1'b1 of TF, and 1'b1 represents 1-bit binary data with a value of 1. It should be noted that, in this embodiment of this application, the total bit width of the floating point number and the bit width of each field (for example, the bit width D of the first exponent field) generally refer to a bit width occupied during storage. For example, the bit width D of the first exponent field is 8 bits, indicating that a bit width occupied by a value Es (for example, a coded value) of the first exponent field during storage is 8 bits. Details are not described again.

In this embodiment of this application, as described above, for exponent fields (for example, the first exponent field) of different bit widths in the floating point number, a second bit (that is, the next bit of Se, namely, the most significant bit in TF) in the Ei is always 1 (that is, 1'b1). Therefore, the most significant bit 1'b1 may not occupy the bit width of the first exponent field, that is, the bit width D of the first exponent field includes only the exponent sign bit Se and other bits in the TF except the most significant bit 1'b1, thereby saving storage space and reducing data storage and data transfer costs of the floating point number. It should be understood that, based on the coding rule, the most significant bit 1'b1 may be directly supplemented to the TF during subsequent decoding, to quickly and accurately obtain a value Ei (which may be understood as a decoded value of the first exponent field in the floating point number, and is used for being input to the computing unit for subsequent corresponding computation) of the second exponent field in the normalized data.

It should be noted that {Se, 1'b1} is a bit-level concatenation of Se and 1'b1, and bit widths of Se and 1'b1 are both 1 bit, so a bit width of {Se, 1b'1} is 2 bits. In addition, a (binary) value of {Se, 1'b1} is a value obtained after Se and 1'b1 are concatenated. For example, Se is 0, and the value of {Se, 1'b1} is 01. For another example, Se is 1, and the value of {Se, 1'b1} is 11. Similarly, {Se, TF[2:D]} is a bit-level concatenation of Se and TF[2:D], and {Se, 1'b1, TF[2:D]} is a bit-level concatenation of Se, 1'b1 and TF[2:D]. For example, Se is 0, TF[2:D] is 1011, a value of {Se, TF[2:D]} is 01011, and a value of {Se, 1'b1, TF[2:D]} is 011011. Details are not described herein again. For details, refer to examples in subsequent embodiments.

In a possible implementation, a coding manner of the exponent bit width field is integer coding; a bit width occupied by the exponent bit width field in the total bit width N is DW; and the method further includes: coding, by using the integer coding, any value of 0 to $2^{DW}-1$ with the bit width DW occupied by the exponent bit width field, where the bit width D is 0 to $2^{DW}-1$.

In this embodiment of this application, the exponent bit width field may be coded by using a simple integer. In this case, the bit width of the exponent bit width field is fixed (for example, DW), and may be used for coding any value of 0 to $2^{DW}-1$. In this way, complexity of coding and subsequent decoding can be reduced, hardware overhead can be reduced, and overall computing efficiency based on the floating point number can be improved on the basis of improving coding and decoding efficiency.

In a possible implementation, a coding manner of the exponent bit width field is conventional prefix coding; a bit width occupied by the exponent bit width field in the total bit width N is DW1 or DW2, and DW1 is less than DW2; and the method further includes: coding, by using the conventional prefix coding, any one of K1 values with the bit width DW1 occupied by the exponent bit width field, or any one of K2 values with the bit width DW2 occupied by the exponent bit width field, where a maximum value of the K1 values is less than a minimum value of the K2 values, and the bit width D belongs to the K1 values or the K2 values.

In this embodiment of this application, the exponent bit width field may employ conventional prefix coding in prefix coding, that is, smaller data (for example, any one of the K1 values) is coded with a shorter bit width (for example, DW1), and larger data (for example, any one of the K2 values, where the maximum value of the K1 values is less than the minimum value of the K2 values) is coded with a longer bit width (for example, DW2, where DW1 is less than DW2), so that a bit width of a mantissa field of a value near an exponent center can be effectively increased, that is, precision of the value near the exponent center can be improved.

In a possible implementation, a coding manner of the exponent bit width field is unconventional prefix coding, a bit width occupied by the exponent bit width field in the total bit width N is DW1 or DW2, and DW1 is less than DW2; and the method further includes: coding, by using the unconventional prefix coding, any one of P1 values with the bit width DW1 occupied by the exponent bit width field, or any one of P2 values with the bit width DW2 occupied by the exponent bit width field, where a minimum value of the P1 values is greater than a maximum value of the P2 values, and the bit width D belongs to the P1 values or the P2 values.

In this embodiment of this application, the exponent bit width field may employ unconventional prefix coding in prefix coding, that is, larger data (for example, any one of the P1 values) is coded with a shorter bit width (for example, DW1), and smaller data (for example, any one of the P1 values, where the minimum value of the P1 values is greater than the maximum value of the P2 values) is coded with a longer bit width (for example, DW2, where DW1 is less than DW2), so that step change of the bit width of the mantissa field can be smoothed, that is, step change of numerical precision can be smoothed.

In a possible implementation, when the first exponent field is all 1s and the first mantissa field is all 0s, the first sign field is 0 or 1, and the first floating point number is positive or negative 0; when the first exponent field is all 1s and the first mantissa field is not 0, the first sign field is 0 or 1, and the first floating point number is a subnormal value; when the Se of the first exponent field is 0, the TF is all 1s, and the first mantissa field is all 0s, the first sign field is 0 or 1, and the first floating point number is positive or negative infinity; or when the Se of the first exponent field is 0, the TF is all 1s, and the first mantissa field is not 0, the first sign field is 0 or 1, and the first floating point number is not a number (not a number, NaN).

In this embodiment of this application, the floating point number may be represented as standard normalized data (generally a constant) through a value of each field, or may be represented as some special values through a customized setting based on an actual requirement. For example, when the Se of the exponent field is 0, the TF is all 1s (for example, 111, the bit width of the exponent field is 3 bits), the mantissa field is all 0s, and the sign field is 0, a truth value that corresponds to the normalized data corresponding to the floating point number is generally $(-1)^0 \times 2^{-8+Ec} \times 1$, however, the floating point number in this case may also be represented as positive or negative infinity. For another example, when the Se of the exponent field is 0, the TF is all 1s (for example, 111, the bit width of the exponent field is 3 bits), the mantissa field is not 0 (for example, 101, the bit width of the mantissa field is 3 bits), and the sign field is 0, a truth value that corresponds to the normalized data corresponding to the floating point number is generally $(-1)^0 \times 2^{-8+EC} \times (1.101)$, however, the floating point number in this case may also be represented as not a number NaN, and the like. Therefore, value representation of the floating point number can be greatly enriched, thereby meeting different requirements in general-purpose computing, high performance computing, or AI training.

In a possible implementation, the method further includes: obtaining first data, where the first data is a second floating point number in a format different from that of the first floating point number, or the first data is an uncoded operation result, and the operation result includes a sign bit, an exponent, and a mantissa; and coding the first sign field, the exponent bit width field, the first exponent field, and the first mantissa field according to a value represented by the first data to obtain the first floating point number.

In this embodiment of this application, another data format (for example, FP16/FP32/FP64) or an uncoded operation result obtained by computation may be converted into a corresponding floating point number (for example, the first floating point number) based on floating point data formats of a sign field, an exponent bit width field, an exponent field, and a mantissa field defined in this application, thereby greatly reducing data storage or data transfer costs of the floating point number.

According to a second aspect, an embodiment of this application provides an apparatus for processing a floating point number. The apparatus includes a first processor, configured to: obtain a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; and obtain normalized data corresponding to the first floating point number based on the first sign field, the exponent bit width field, the first exponent field, and the first mantissa field, where the normalized data includes a second sign field, a second exponent field, and a second mantissa field in a scientific notation method. Optionally, the first processor may be a decoder, or a processor integrated with a decoder.

In a possible implementation, the first floating point number is used for data storage or data transfer, the normalized data is used for being input to a computing unit to participate in corresponding computation, and the computing unit includes one or more of a scalar computing unit, a vector computing unit, a matrix computing unit, or a tensor computing unit.

In a possible implementation, the first processor is specifically configured to: obtain, based on the first sign field, the second sign field in the normalized data; determine, based on the bit width D indicated by the exponent bit width field, the first exponent field and the first mantissa field from the first floating point number, and obtain, based on the first exponent field and the first mantissa field, the second exponent field and the second mantissa field in the normalized data.

In a possible implementation, a truth value corresponding to the normalized data satisfies the following formula:

$$X=(-1)^{S}\times2^{Ei+Ec}\times(1+M)$$

X is a truth value corresponding to the normalized data; S is a value of the second sign field, the value of the second sign field is the same as that of the first sign field, and S is 0 or 1; Ei is a value of the second exponent field; Ec is a preset exponent center; and M is a value of the second mantissa field.

In a possible implementation, the apparatus further includes a second processor, and the second processor is configured to: determine, based on the bit width D indicated by the exponent bit width field, a numerical range E corresponding to the first exponent field during coding, where Ei belongs to the numerical range E, and the numerical range E satisfies the following formula:

$$E=(-1)^{Se}\times[2^{D-1}, (2^{D}-1)]$$

Se is a sign bit of Ei, and Se is 0 or 1.

In a possible implementation, when D is equal to 0, Ei=0; when D is equal to 1, the value of the first exponent field is Es={Se}, and Ei={Se, 1'b1}; or when D is greater than 1, the value of the first exponent field is Es={Se, TF[2:D]}, and Ei={Se, 1'b1, TF[2:D]}, where TF is an amplitude of the Ei, 1'b1 is a most significant bit in the TF, 1'b1 does not occupy a bit width in the first exponent field, and a bit width of the second exponent field is D+1; TF[2:D] represents remaining bits in the TF except the most significant bit 1'b1, and a bit width occupied by the TF[2:D] in the first exponent field is D-1; and in the Ei, when D is greater than or equal to 1, a next bit of Se is the most significant bit 1'b1 of TF, and 1'b1 represents 1-bit binary data with a value of 1.

In a possible implementation, a coding manner of the exponent bit width field is integer coding; a bit width occupied by the exponent bit width field in the total bit width N is DW; and the second processor is configured to: code, by using the integer coding, any value of 0 to $2^{DW}-1$ with the bit width DW occupied by the exponent bit width field, where the bit width D is 0 to $2^{DW}-1$.

In a possible implementation, a coding manner of the exponent bit width field is conventional prefix coding; a bit width occupied by the exponent bit width field in the total bit width N is DW1 or DW2, and DW1 is less than DW2; and the second processor is configured to: code, by using the conventional prefix coding, any one of K1 values with the bit width DW1 occupied by the exponent bit width field, or any one of K2 values with the bit width DW2 occupied by the exponent bit width field, where a maximum value of the K1 values is less than a minimum value of the K2 values, and the bit width D belongs to the K1 values or the K2 values.

In a possible implementation, a coding manner of the exponent bit width field is unconventional prefix coding, a bit width occupied by the exponent bit width field in the total bit width N is DW1 or DW2, and DW1 is less than DW2; and the second processor is configured to: code, by using the unconventional prefix coding, any one of P1 values with the bit width DW1 occupied by the exponent bit width field, or any one of P2 values with the bit width DW2 occupied by the exponent bit width field, where a minimum value of the P1 values is greater than a maximum value of the P2 values, and the bit width D belongs to the P1 values or the P2 values.

In a possible implementation, when the first exponent field is all 1s and the first mantissa field is all 0s, the first sign field is 0 or 1, and the first floating point number is positive or negative 0; when the first exponent field is all 1s and the first mantissa field is not 0, the first sign field is 0 or 1, and the first floating point number is a subnormal value; when the Se of the first exponent field is 0, the TF is all 1s, and the first mantissa field is all 0s, the first sign field is 0 or 1, and the first floating point number is positive or negative infinity; or when the Se of the first exponent field is 0, the TF is all 1s, and the first mantissa field is not 0, the first sign field is 0 or 1, and the first floating point number is not a number NaN.

In a possible implementation, the second processor is configured to: obtain first data, where the first data is a second floating point number in a format different from that of the first floating point number, or the first data is an uncoded operation result, and the operation result includes a sign bit, an exponent, and a mantissa; and code the first sign field, the exponent bit width field, the first exponent field, and the first mantissa field according to a value represented by the first data to obtain the first floating point number. Optionally, the second processor may be an encoder, or a processor integrated with an encoder.

According to a third aspect, an embodiment of this application provides an apparatus for processing a floating point number. The apparatus includes a processor and a memory, where the processor is coupled to the memory, the memory is configured to store a computer program code, the computer program code includes computer instructions, and the processor invokes the computer instructions to perform:

obtaining a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; and obtaining normalized data corresponding to the first floating point number based on the first sign field, the exponent bit width field, the first exponent field, and the first mantissa field, where the normalized data includes a second sign field, a second exponent field, and a second mantissa field in a scientific notation method.

In a possible implementation, the first floating point number is used for data storage or data transfer, the normalized data is used for being input to a computing unit to participate in corresponding computation, and the computing unit includes one or more of a scalar computing unit, a vector computing unit, a matrix computing unit, or a tensor computing unit.

In a possible implementation, the processor invokes the computer instructions to specifically perform: obtaining, based on the first sign field, the second sign field in the normalized data; and determining, based on the bit width D indicated by the exponent bit width field, the first exponent field and the first mantissa field from the first floating point number, and obtaining, based on the first exponent field and the first mantissa field, the second exponent field and the second mantissa field in the normalized data.

In a possible implementation, a truth value corresponding to the normalized data satisfies the following formula:

$$X=(-1)^{S} \times 2^{Ei+Ec} \times (1+M)$$

X is a truth value corresponding to the normalized data; S is a value of the second sign field, the value of the second sign field is the same as that of the first sign field, and S is 0 or 1; Ei is a value of the second exponent field; Ec is a preset exponent center; and M is a value of the second mantissa field.

In a possible implementation, the processor invokes the computer instructions to further perform: determining, based on the bit width D indicated by the exponent bit width field, a numerical range E corresponding to the first exponent field during coding, where Ei belongs to the numerical range E, and the numerical range E satisfies the following formula:

$$E=(-1)^{Se} \times [2^{D-1}, (2^{D}-1)]$$

Se is a sign bit of Ei, and Se is 0 or 1.

In a possible implementation, when D is equal to 0, Ei=0; when D is equal to 1, the value of the first exponent field is Es={Se}, and Ei={Se, 1'b1}; or when D is greater than 1, the value of the first exponent field is Es={Se, TF[2:D]}, and Ei={Se, 1'b1, TF[2:D]}, where TF is an amplitude of the Ei, 1'b1 is a most significant bit in the TF, 1'b1 does not occupy a bit width in the first exponent field, and a bit width of the second exponent field is D+1; TF[2:D] represents remaining bits in the TF except the most significant bit 1'b1, and a bit width occupied by the TF[2:D] in the first exponent field is D-1; and in the Ei, when D is greater than or equal to 1, a next bit of Se is the most significant bit 1'b1 of TF, and 1'b1 represents 1-bit binary data with a value of 1.

In a possible implementation, a coding manner of the exponent bit width field is integer coding; a bit width occupied by the exponent bit width field in the total bit width N is DW; and the processor invokes the computer instructions to further perform: coding, by using the integer coding, any value of 0 to $2^{DW}-1$ with the bit width DW occupied by the exponent bit width field, where the bit width D is 0 to $2^{DW}-1$.

In a possible implementation, a coding manner of the exponent bit width field is conventional prefix coding; a bit width occupied by the exponent bit width field in the total bit width N is DW1 or DW2, and DW1 is less than DW2; and the processor invokes the computer instructions to further perform: coding, by using the conventional prefix coding, any one of K1 values with the bit width DW1 occupied by the exponent bit width field, or any one of K2 values with the bit width DW2 occupied by the exponent bit width field, where a maximum value of the K1 values is less than a minimum value of the K2 values, and the bit width D belongs to the K1 values or the K2 values.

In a possible implementation, a coding manner of the exponent bit width field is unconventional prefix coding, a bit width occupied by the exponent bit width field in the total bit width N is DW1 or DW2, and DW1 is less than DW2; and the processor invokes the computer instructions to further perform: coding, by using the unconventional prefix coding, any one of P1 values with the bit width DW1 occupied by the exponent bit width field, or any one of P2 values with the bit width DW2 occupied by the exponent bit width field, where a minimum value of the P1 values is greater than a maximum value of the P2 values, and the bit width D belongs to the P1 values or the P2 values.

In a possible implementation, when the first exponent field is all 1s and the first mantissa field is all 0s, the first sign field is 0 or 1, and the first floating point number is positive or negative 0; when the first exponent field is all 1s and the first mantissa field is not 0, the first sign field is 0 or 1, and the first floating point number is a subnormal value; when the Se of the first exponent field is 0, the TF is all 1s, and the first mantissa field is all 0s, the first sign field is 0 or 1, and the first floating point number is positive or negative infinity; or when the Se of the first exponent field is 0, the TF is all 1s, and the first mantissa field is not 0, the first sign field is 0 or 1, and the first floating point number is not a number NaN.

In a possible implementation, the apparatus further includes a transmission interface, the transmission interface is coupled to the processor; the transmission interface is configured to obtain first data; the first data is a second floating point number in a format different from that of the first floating point number, or the first data is an uncoded operation result, and the operation result includes a sign bit, an exponent, and a mantissa; and the processor invokes the computer instructions to further perform: coding the first sign field, the exponent bit width field, the first exponent field, and the first mantissa field according to a value represented by the first data to obtain the first floating point number.

According to a fourth aspect, an embodiment of this application provides a computing method based on a floating point number, including:

obtaining a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; obtaining normalized data corresponding to the first floating point number based on the first sign field, the exponent bit width field, the first exponent field, and the first mantissa field, where the normalized data includes a second sign field, a second exponent field, and a second mantissa field in a scientific notation method; and inputting the normalized data to a computing unit to participate in corresponding computation, where the computing unit includes one or more of a scalar computing unit, a vector computing unit, a matrix computing unit, or a tensor computing unit.

In a possible implementation, the method further includes: obtaining first data, where the first data is a second floating point number in a format different from that of the first floating point number, or the first data is an uncoded operation result, and the operation result includes a sign bit, an exponent, and a mantissa; and coding the first sign field, the exponent bit width field, the first exponent field, and the first mantissa field according to a value represented by the first data to obtain the first floating point number, where the first floating point number is used for data storage or data transfer.

According to a fifth aspect, an embodiment of this application provides an electronic device. The electronic device includes a processor, and the processor is configured to support the electronic device to perform corresponding functions in the method for processing a floating point number according to the first aspect or corresponding functions in the computing method based on a floating point number according to the fourth aspect. The electronic device may further include a memory. The memory is configured to be coupled to the processor, and the memory stores program instructions and data that are necessary for the electronic device. The electronic device may further include a communication interface, configured for communication between the electronic device and another device or a communications network.

According to a sixth aspect, an embodiment of this application provides a computer-readable storage medium. The computer-readable storage medium stores a computer program that, when executed by a processor, implements a flow of any method for processing a floating point number according to the first aspect or a flow of any computing method based on a floating point number according to the fourth aspect.

According to a seventh aspect, an embodiment of this application provides a computer program. The computer program includes instructions. When the computer program is executed by a computer, the computer is enabled to perform a flow of any method for processing a floating point number according to the first aspect or a flow of any computing method based on a floating point number according to the fourth aspect.

According to an eighth aspect, an embodiment of this application provides a chip. The chip includes a processor and a communication interface. The processor is configured to invoke instructions from the communication interface and run the instructions. When the processor executes the instructions, the chip is enabled to perform a flow of any method for processing a floating point number according to the first aspect or a flow of any computing method based on a floating point number according to the fourth aspect.

According to a ninth aspect, an embodiment of this application provides a chip system. The chip system includes the apparatus for processing a floating point number according to any one of the foregoing second aspect or the apparatus for processing a floating point number according to any one of the foregoing third aspect, and is configured to implement functions related to a flow of any method for processing a floating point number according to the first aspect or functions related to a flow of any computing method based on a floating point number according to the fourth aspect. In a possible design, the chip system further includes a memory, and the memory is configured to store program instructions and data that are necessary for a method for processing a floating point number. The chip system may include a chip, or may include a chip and another discrete component.

## BRIEF DESCRIPTION OF DRAWINGS

FIG. 1 is a schematic diagram of a system architecture according to an embodiment of this application.

FIG. 2 is a schematic diagram of a structure of a decoder based on a floating point number according to an embodiment of this application.

FIG. 3 is a schematic diagram of a structure of an encoder based on a floating point number according to an embodiment of this application.

FIG. 4 is a schematic flowchart of a method for processing a floating point number according to an embodiment of this application.

FIG. 5 is a schematic diagram of mantissa-exponent distribution of a HiF64 according to an embodiment of this application.

FIG. 6 is a schematic diagram of mantissa-exponent distribution of a HiF32 according to an embodiment of this application.

FIG. 7 is a schematic diagram of mantissa-exponent distribution of a HiF16 according to an embodiment of this application.

FIG. 8 is a schematic diagram of mantissa-exponent distribution of a HiF8 according to an embodiment of this application;

FIG. 9 is a schematic diagram of a structure of an apparatus for processing a floating point number according to an embodiment of this application.

FIG. 10 is a schematic diagram of a structure of another apparatus for processing a floating point number according to an embodiment of this application.

FIG. 11 is a schematic diagram of a structure of an electronic device according to an embodiment of this application.

## DESCRIPTION OF EMBODIMENTS

The following describes embodiments of this application with reference to the accompanying drawings in embodiments of this application.

In the specification, claims, and accompanying drawings of this application, terms "first", "second", and the like are intended to distinguish between different objects but do not indicate a particular order. In addition, terms "include", "have", or any other variant thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device. It should be noted that when an element is referred to as "coupled" or "connected" to another one or more elements, the element may be directly connected to the another one or more elements, or may be indirectly connected to the another one or more elements.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, a and b, a and c, b and c, or a, b, and c, where a, b, and c may be singular or plural.

An "embodiment" mentioned in this specification means that a particular characteristic, structure, or feature described with reference to embodiments may be included in at least one embodiment of this application. The phrase shown in various locations in the specification may not necessarily refer to a same embodiment, and is not an independent or optional embodiment exclusive from another embodiment. It is explicitly and implicitly understood by a person skilled in the art that embodiments described herein may be combined with another embodiment.

Terminologies such as "component", "module", and "system" used in this specification are used to indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As shown in figures, an application that runs on a processor and a processor may be components. One or more components may reside within a process and/or a thread of execution, and a component may be located on one computer and/or distributed between two or more computers. In addition, these components may be executed from various computer-readable media that store various data structures. For example, the components may communicate by using a local and/or remote process and based on, for example, a signal having one or more data packets (for example, data from two components interacting with another component in a local system, a distributed system, and/or across a network such as the Internet interacting with other systems by using the signal).

For ease of understanding by a person skilled in the art, some terms in this application are described first.

(1) A floating point number, that is, floating-point data representation is a scientific notation. In fields of finance, engineering, scientific research, aerospace, and the like, a large amount of data needs to be stored, computed, and transmitted every day. Floating-point data accounts for a large proportion, for example, real-time prices and historical K-line data of stocks, and net values and yields of funds. The foregoing data is usually widely used in a form of floating point numbers. A floating point number with precision such as conventional FP16/FP32/FP64 defined in IEEE754 usually includes a sign field, an exponential field (that is, an exponent field), and a mantissa field. For example, binary 100.101 (that is, 4.625 in decimal) is used as an example, a truth value corresponding to a normal floating point number is $(-1)^0 \times 2^2 \times 1.00101$, where an exponent 0 of a base number -1 is a value of a sign field in the floating point number (that is, a sign, used for representing positive or negative, where 0 represents positive, and 1 represents negative), an exponent 2 of a base number 2 is obtained by subtracting a fixed bias (bias) from a value represented by an exponent field in the floating point number (for example, the value may be understood as a decoded value of the exponent field in the floating point number) and is used for indicating a carry digit of a decimal point (for example, a carry digit of a decimal point from 100.101 to 1.00101 is 2), and 1.00101 is a mantissa. It may be understood that, because the first decimal point shall be 1, a mantissa field in the floating point number actually stores only data after the decimal point, that is, 00101, which spares a binary bit to store more mantissas.

As described above, it should be understood that a bit width of the exponent field in the floating point number determines a numerical range that can be represented by the floating point number. A larger value of the exponent field indicates a larger value represented by the floating point number. Correspondingly, a bit width of the mantissa field determines numerical precision that can be represented by the floating point number. A larger value of the mantissa field indicates higher precision represented by the floating point number.

In some embodiments of this application, a floating point number (HiFloat) is provided. Compared with conventional FP16/FP32/FP64 defined in IEEE 754, a Dot field (that is, an exponent bit width field) used for indicating a bit width of an exponent field is added in addition to a sign field, an exponent field, and a mantissa field. Under a same total bit width, both the bit width of the exponent field and a bit width of the mantissa field may dynamically change with a value of the Dot field, to meet requirements for different numerical ranges and precision of floating point numbers in different scenarios. In addition, as described above, the bias is a different constant for the conventional FP16/FP32/FP64. For example, the bias of FP32 is 127, and the bias of FP64 is 255. However, in the floating point number provided in embodiments of this application, the bias may be a preset exponent center, and a value of the exponent center may be customized depending on an actual requirement, and is generally 0, or may be any other possible value (for example, ±2 or ±3). For details, refer to descriptions in the following embodiments. Details are not described herein again.

(2) A true form (true form, TF) relates to a binary fixed-point representation method for a digit in a computer. In a conventional true form representation method, a sign bit (that is, a most significant bit of a conventional true form is a sign bit) is added before a value, to represent a positive or negative value, where a sign bit 0 indicates positive, a sign bit 1 indicates negative (also including +0 and -0), and remaining bits in the true form except the sign bit are used for representing a size of the value, that is, an amplitude of the true form. For example, a true form 1001 represents +1, and 0011 represents -3.

In some embodiments of this application, the exponent field in the floating point number may be coded in a manner that an exponent sign bit follows the amplitude of the true form, for example, { Se, TF[2:end]}, where the exponent sign bit Se is a sign bit extracted from an initial true form and is used for representing a positive or negative value of the exponent field, and TF is used for representing an amplitude of the value of the exponent field. It should be noted that, based on the coding method provided in this application, for different bit widths of the exponent field, a most significant bit of the amplitude TF in the exponent field is always 1 (that is, 1'b1). Therefore, the most significant bit 1'b1 may not occupy a width during coding, that is, the most significant bit 1'b1 is hidden, and is not actually stored. During subsequent decoding, the most significant bit 1'b1 may be directly supplemented, to obtain {Se, 1'b1, TF[2:end]}. Therefore, storage space can be greatly saved, and costs of data storage and data transfer can be reduced.

(3) Integer (integer) coding means encoding an integer by using a binary code with a fixed length, for example, coding 0 to 7 by using a binary code with 3 bits and coding 0 to 15 by using a binary code with 4 bits.

(4) Coding with a prefix code (prefix code) is prefix coding. In a coding scheme, if any code is not a prefix (a leftmost substring) of any other code, the code is referred to as a prefix code, for example, unequal-length codes: 1, 01, 010, 0011, or 00, 01, 10, 1100, 1101, and equal-length codes: 00, 01, 10, 11. It may be understood that the equal-length codes are usually prefix codes. Prefix coding may ensure that a compressed file is correctly decoded without causing ambiguity. In some embodiments of this application, the Dot field added to the floating point number may be coded through prefix coding. Similarly, in this embodiment of this application, based on an actual requirement, the Dot field may be further coded in different prefix coding manners such as conventional prefix coding and unconventional prefix coding. For details, refer to descriptions in the following embodiments. Details are not described herein again.

First, to facilitate understanding of embodiments of this application, a technical problem to be specifically resolved in this application is further analyzed and proposed. In the prior art, a related technology about a floating point number includes a plurality of technical solutions. The following exemplifies common solutions.

The conventional IEEE 754 binary floating point number arithmetic standard defines three fields included in a floating point number, respectively a sign field, an exponent field, and a mantissa field. A bit width of each field in a floating point number of each precision is fixed. For details, refer to Table 1 below.

**Table 1**

|  | Sign field | Exponent field | Mantissa field |
|---|---|---|---|
| FP16 | 1 bit | 5 bits | 10 bits |
| FP32 | 1 bit | 8 bits | 23 bits |
| FP64 | 1 bit | 11 bits | 52 bits |

As shown in Table 1, an FP 16 includes a 1-bit (bit) sign field, a 5-bit exponent field, and a 10-bit mantissa field; an FP 32 includes a 1-bit sign field, an 8-bit exponent field, and a 23-bit mantissa field; and an FP 64 includes a 1-bit sign field, an 11-bit exponent field, and a 52-bit mantissa field. Apparently, bit widths of the exponent field and the mantissa field in the floating point number of each precision are always fixed. Therefore, when higher precision or a larger numerical range is required for computation, only a data format with a larger total bit width (for example, FP64) can be selected. However, this easily causes a waste of a bit width of an exponent field or a mantissa field in the FP64, thereby occupying unnecessary storage space. For example, for AI mixed precision training, an existing floating point data format or a numerical range, which is not large enough, often involves a large quantity of scaling (scaling) operations; or low precision affects a convergence speed and a final function. However, if requirements for a numerical range and precision need to be met, a total bit width is too large, and consequently, data storage and data transfer overheads are too high. For another example, for the field of HPC, increasing applications no longer require high-precision data formats such as FP64. However, the precision of FP32 is slightly strained for some HPC applications.

On this basis, a posit floating point data format is further proposed in the industry. A regime field with a dynamically changing bit width is added to the posit, and is combined with an exponent field with a fixed bit width to jointly represent an exponent value of data. In this case, if there is a bit width remaining in a total bit width, the bit width is reserved for a mantissa. The regime field uses a special prefix code, including: detecting several consecutive 0s and a terminator 1, or several consecutive 1s and a terminator 0, which respectively represent different values k. Then, the value k and the value e of the exponent field are concatenated to form {k, e}, where {k, e} represents a complete exponent value.

As described above, the existing posit floating point number may implement a mantissa field with a dynamically changing bit width, that is, implement dynamically changing precision. However, the bit width of the exponent field in the posit floating point number is still fixed, and the added regime field occupies a larger bit width, and therefore coding and decoding processes of the posit floating point number are very complex, and hardware overheads are high. In addition, due to coding particularity of the regime field, a numerical range of posit is not large enough to meet an actual application requirement.

Therefore, to resolve a problem in an existing floating point data representation method that precision, a numerical range, and a total bit width are difficult to be obtained at the same time in the fields of general-purpose computing, HPC, AI, and the like, a technical problem to be actually resolved in this application includes the following aspects: a new floating point data format (HiFloat) is provided, a Dot field (namely, an exponent bit width field) is additionally defined in addition to a conventional sign field, a conventional exponent field, and a conventional mantissa field, and a value of the Dot field is used for indicating a bit width occupied by the exponent field in a total bit width of a floating point number. Therefore, the bit width of the exponent field and a bit width of the subsequent mantissa field may dynamically change with the value of the Dot field, that is, a dynamically changing numerical range and numerical precision are realized. By using the Dot field defined in this application, a constraint that bit widths of an exponent field and a mantissa field in a conventional floating point data format are fixed is eliminated, and requirements for different numerical ranges and numerical precision of floating point numbers in different scenarios are met to a great extent without increasing a total bit width, that is, without increasing data storage and data transfer costs.

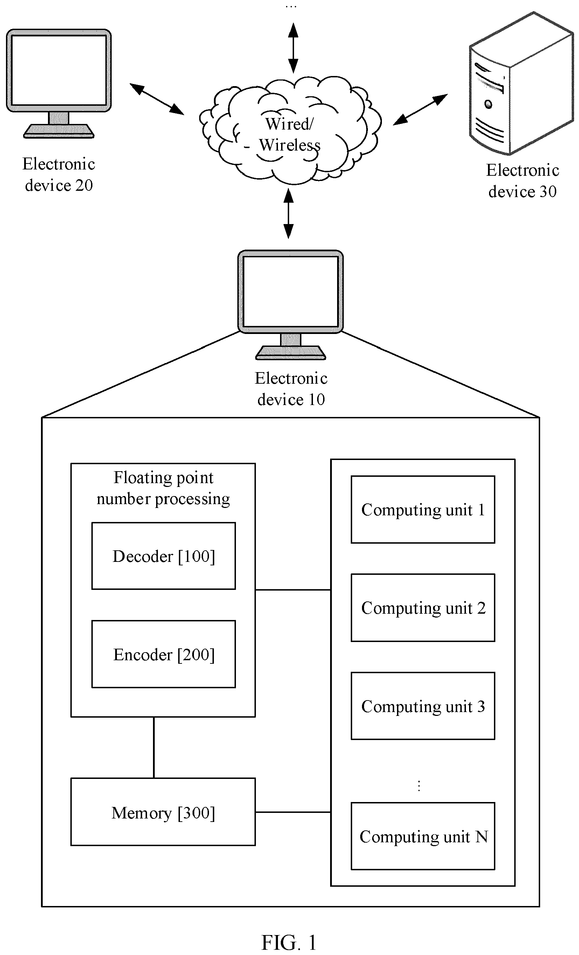

Refer to FIG. 1. FIG. 1 is a schematic diagram of a system architecture according to an embodiment of this application. Technical solutions in embodiments of this application may be specifically implemented in the system architecture shown in FIG. 1 or a similar system architecture. As shown in FIG. 1, the system architecture may include a plurality of electronic devices, for example, an electronic device 10, an electronic device 20, and an electronic device 30. Communication connections may be established between the electronic device 10, the electronic device 20, and the electronic device 30 in a wired or wireless network (for example, wireless-fidelity (wireless-fidelity, WiFi), Bluetooth, and a mobile network) manner, to perform data storage, computation, transmission, and the like based on floating point numbers in various fields (finance, engineering, scientific research, aerospace, and the like).

As shown in FIG. 1, the electronic device 10 as an example may include a decoder 100 and an encoder 200 that are used for floating point number processing, a plurality of corresponding computing units (for example, a computing unit 1, a computing unit 2, a computing unit 3, ..., a computing unit N), a memory 300, and the like. Specifically, when the electronic device 10 performs general-purpose computing, high performance computing, or AI training, a large amount of floating point data needs to be used. In this case, the electronic device may obtain, by using the decoder 100, normalized data of a corresponding floating point number (the floating point number may be obtained from the local memory 300, or may be obtained from the electronic device 20 or the electronic device 30 in a wired or wireless network manner) based on a method for processing a floating point number in some embodiments of this application, and transmit the normalized data to a computing unit, and corresponding computation is completed by the computing unit. Correspondingly, an operation result finally obtained by the computing unit may also be coded into a floating point number by the encoder 200, and the floating point number may be used for data storage and data transfer. It should be noted that this embodiment of this application provides a floating point data format (HiFloat), where a Dot field is additionally defined on the basis of a standard sign field, a standard exponent field, and a standard mantissa field, that is, a floating point number in this embodiment of this application includes a sign field, a Dot field, an exponent field, and a mantissa field. The Dot field is used for indicating a bit width occupied by the exponent field in the floating point number. Therefore, the bit width of the exponent field in the floating point number may dynamically change with a value of the Dot field, and a bit width of the mantissa field in the floating point number also dynamically changes accordingly, thereby meeting requirements for different numerical ranges and precision of floating point numbers in various scenarios. In this embodiment of this application, different requirements for numerical ranges and numerical precision of floating point numbers in various scenarios (for example, general-purpose computing, high performance computing, or AI training) can be flexibly met without additionally increasing a total bit width, that is, without additionally increasing data storage or data transfer costs, thereby improving use effects of the floating point numbers. Specifically, for general-purpose computing and high performance computing, a higher convergence speed and precision of a computing task may be obtained under a same total bit width (that is, same data storage or data transfer overheads) in this embodiment of this application. For AI neural network training and inference, requirements for functions and accuracy of training and inference of a neural network and the like may be met under a smaller bit width (that is, lower data storage or data transfer overheads) in this embodiment of this application.

Optionally, for specific structures and functions of the electronic device 20 and the electronic device 30 in FIG. 1, refer to the electronic device 10. In some possible embodiments, the electronic device 10, the electronic device 20, and the electronic device 30 may include more or fewer components than those shown in FIG. 1. This is not specifically limited in this embodiment of this application.

In conclusion, the electronic device 10, the electronic device 20, and the electronic device 30 may be an intelligent wearable device, a smartphone, a smart home, a tablet computer, a notebook computer, a desktop computer, an in-vehicle computer, a server, or the like that has the foregoing functions, and may be a server, a server cluster including a plurality of servers, a cloud computing service center, or the like. This is not specifically limited in this embodiment of this application.

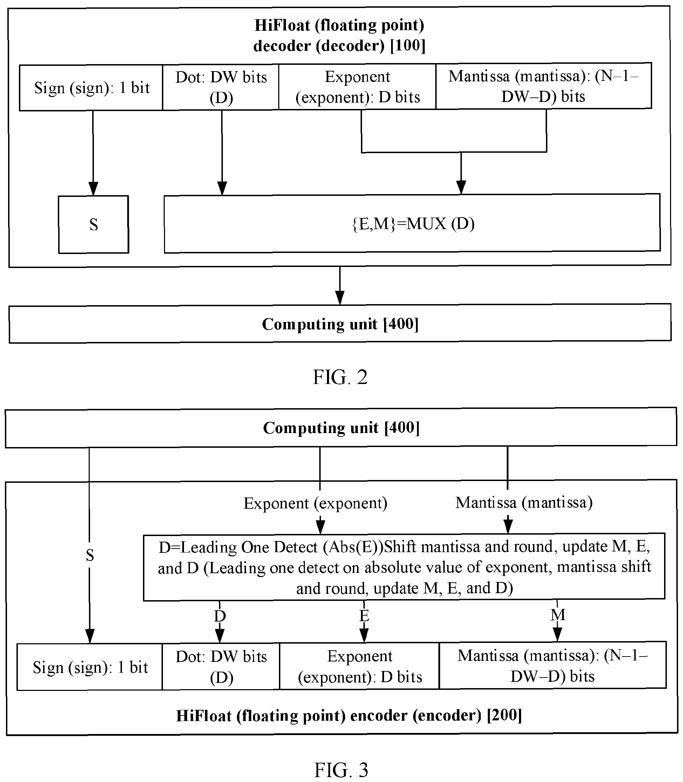

Further, refer to FIG. 2. FIG. 2 is a schematic diagram of a structure of a decoder based on a floating point number according to an embodiment of this application. The technical solution in this embodiment of this application may be specifically implemented in the structure shown in FIG. 2 or a similar structure. As shown in FIG. 2, a floating point number in this embodiment of this application sequentially includes a sign field, a Dot field, an exponent field, and a mantissa field, with a total bit width of N. The sign field occupies 1 bit, and is a most significant bit in the floating point number. The Dot field occupies DW bits (a value of the Dot field is D), the exponent field occupies D bits, and the mantissa field occupies (N-1-DW-D) bits. As shown in FIG. 2, based on the floating point data format, first, a value of the sign field in the floating point number may be directly read and output (S=0 or 1). Second, the decoder 100 may extract, based on the bit width DW of the Dot field, the Dot field after the sign field, perform a multiplexing (multiplexer, MUX) operation on the Dot field, and decode the Dot field based on a preset coding rule (for example, a coding rule shown in Table 15 below) to obtain the value D of the Dot field. Then, the decoder 100 may quickly and accurately extract, based on the value D, the exponent field after the Dot field and the mantissa field after the exponent field, and decode values represented by the exponent field and the mantissa field. So far, the decoder may obtain, according to the decoded values of the exponent field and the mantissa field in the floating point number and the value of the sign field, normalized data corresponding to the floating point number, that is, the normalized data may include the decoded exponent field, the decoded mantissa field, and the sign field. Optionally, the normalized data corresponds to a truth value $X=(-1)^S \times 2^{Ei+Ec} \times (1+M)$, where S is a value of the sign field, Ei is a value of the exponent field in the normalized data (that is, the decoded value of the exponent field in the floating point number), M is a value of the mantissa field in the normalized data (that is, the decoded value of the mantissa field in the floating point number), and Ec is a preset exponent center (which is generally 0, or may be 1, -2, or the like). Then, the decoder 100 may transmit the normalized data obtained by decoding to a computing unit 400 connected to the decoder 100, and the computing unit 400 receives the normalized data and performs corresponding computation.

For example, a floating point number input to the decoder 100 is "11010110", a total bit width is 8 bits, a first bit "1" is a sign field, and a second bit to a third bit "10" is an exponent field. According to a coding rule shown in Table 15, a value of the Dot field obtained by decoding is 3, that is, it is determined that a bit width of the exponent field is 3 bits. Therefore, the decoder 100 may quickly and accurately extract a fourth bit to a sixth bit "101" of the exponent field from the floating point number, a remaining seventh bit to a remaining eighth bit "10" is a mantissa field, Ei=5 and M=0.10 in the normalized data are obtained by decoding based on this, and a truth value $X=(-1)^1 \times 2^3 \times (1.10)$ corresponding to the normalized data may be further obtained by computation.

Further, refer to FIG. 3. FIG. 3 is a schematic diagram of a structure of an encoder based on a floating point number according to an embodiment of this application. The technical solution in this embodiment of this application may be specifically implemented in the structure shown in FIG. 3 or a similar structure. As shown in FIG. 3, a computing unit 400 may input an uncoded operation result (which may include a sign bit, an exponent, and a mantissa) obtained by the computing unit 400 to an encoder 200 connected to the computing unit 400. As shown in FIG. 3, the encoder 200 may code the Dot field, the exponent field, and the mantissa field separately by performing operations such as leading 1 detection on an exponent absolute value in the operation result and mantissa shift and rounding, and finally code the operation result into a HiFloat data format provided in this embodiment of this application shown in FIG. 3, for data storage, data transfer, subsequent computation, and the like.

For example, a sign bit of the operation result output by the computing unit 400 is 1, an exponent is "00011" (that is, 3), a mantissa is "1111", and a coding target is a HiFloat with a total bit width of 8 bits. First, the encoder 200 performs a leading 1 detection on an absolute value "00011" of the exponent until a first 1 is found, to determine that a bit width of an exponent field to be coded this time is 2 bits (a coded value of the exponent field is "01", where 0 is a sign bit of the exponent and represents positive, and a most significant bit "1" in an exponent amplitude "11" may be hidden and does not occupy a width. Details are not described herein again), that is, to determine that a value of a Dot field to be coded this time is 2. For example, still taking a coding rule shown in Table 15 below as an example, a coded value corresponding to the Dot field is "01", a bit width of 2 bits is occupied, and a bit width of a remaining codable mantissa field is 3 bits. However, a bit width of the mantissa "1111" in the input operation result is obviously greater than the bit width of the current codable mantissa field. Therefore, the mantissa "1111" needs to be rounded first to obtain a mantissa "10.000" that includes hidden bits on the left of a decimal point. In this case, the decimal point in the mantissa "10.000" needs to be further shifted leftward by one bit, to obtain a mantissa "1.0000" that includes hidden bits on the left of the decimal point. Correspondingly, the exponent needs to be increased by 1 (that is, the exponent is 4), a final coded value of the exponent field is "000" (similarly, a most significant bit "1" in an exponent amplitude "100" is hidden), and a final coded value of the mantissa field is "00". So far, a floating point number finally obtained by the encoder 200 by coding is "10100000". The most significant bit "1" is a sign bit. It may be understood that the sign bit in the input result may be directly inherited and remains unchanged.

Optionally, data in another format (for example, FP16, FP32, or FP64) may also be input to the encoder 200, and the encoder 200 codes the data into a HiFloat data format in this embodiment of this application, to reduce costs of data storage or data transfer.

In conclusion, the computing unit 400 may be any one of the computing unit 1, the computing unit 2, the computing unit 3, ..., and the computing unit N shown in FIG. 1, and may be specifically a scalar computing unit, a vector computing unit, a matrix computing unit, a tensor computing unit, or the like. Specifically, various computing units are described as follows:

(1) Scalar computing unit

A scalar, also referred to as a scalar quantity, has only a size but no direction. A circuit for scalar computing is referred to as a scalar computing unit. Scalar computing is mainly used for general-purpose computing. In this embodiment of this application, an arithmetic logic unit (arithmetic logic unit, ALU) based on a HiFloat data format may be embedded in an execution unit (execution unit, EXU) of a CPU multi-level pipeline or a scalar computing part of another processor with a similar function.

(2) Vector computing unit

A vector, also referred to as a vector quantity, generally indicates a one-Dimensional array with a length greater than 1. A computing unit that is specially designed for vector computing and has a certain degree of parallelism is referred to as a vector computing unit, for example, a single instruction multiple data (single instruction multiple data, SIMD) processor. The vector computing unit is mainly used in the fields of high performance computing, AI machine learning, and the like, including linear programming, Fourier transform, filtering computation, and solving of mathematical problems such as linear algebra, partial differential equations, and integrals. In this embodiment of this application, an arithmetic execution unit based on a HiFloat data format may be embedded in a vector computing acceleration unit or a vector processor.

(3) Matrix computing unit

A matrix is a 2-Dimensional array arranged in a rectangular array. A computing unit that is specially designed for matrix computing and has a corresponding degree of parallelism is referred to as a matrix computing unit, for example, a systolic array (systolic array) processor. The matrix computing unit is mainly used for matrix computing in the fields of high performance computing, AI machine learning, and the like, including matrix multiplication, matrix inversion, matrix decomposition, and the like. In this embodiment of this application, a matrix unit (matrix unit) based on a HiFloat data format may be embedded in a matrix computing acceleration unit.

(4) Tensor computing unit

A tensor is a multi-Dimensional array with more than two dimensions. A 3-Dimensional array is common. A computing unit that is specially designed for tensor computing and has a corresponding degree of parallelism is referred to as a tensor computing unit. The tensor computing unit is mainly used in a field of AI machine learning, such as convolution operations. In this embodiment of this application, a tensor unit (tensor unit) based on a HiFloat data format may be embedded in a tensor computing acceleration unit.

In conclusion, the structures shown in FIG. 2 and FIG. 3 are merely examples for description. The decoder 100 and the encoder 200 may be disposed in chips such as a general-purpose computing CPU chip, an HPC service acceleration chip, a graphics processing unit (graphics processing unit, GPU), and an embedded neural-network processing unit (neural-network processing units, NPU) in the AI field. This is not specifically limited in this embodiment of this application.

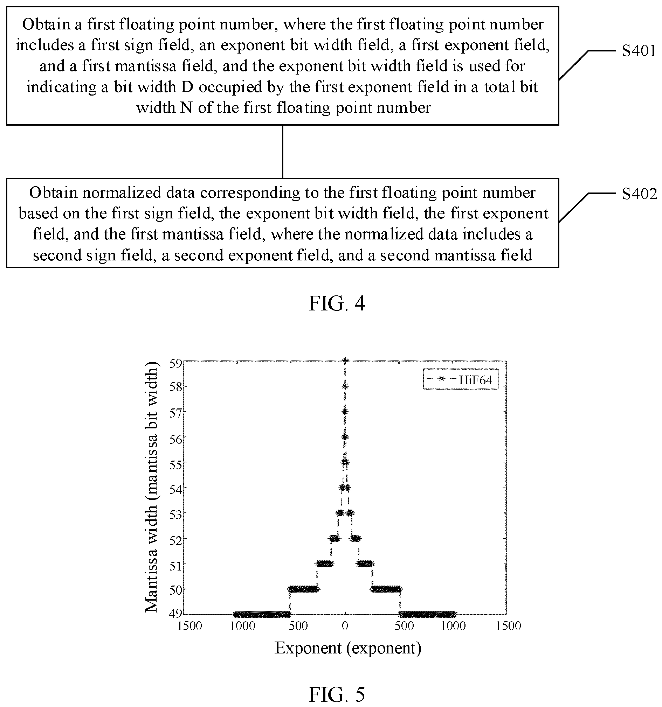

Refer to FIG. 4. FIG. 4 is a schematic flowchart of a method for processing a floating point number according to an embodiment of this application. The method may be applied to the system architecture in FIG. 1 and a corresponding electronic device. The electronic device may be, for example, an intelligent wearable device, a smartphone, a tablet computer, a notebook computer, a desktop computer, an in-vehicle computer, or a server, and may be configured to support and perform a method flow shown in FIG. 4. As shown in FIG. 4, the method for processing a floating point number may include step S401 and step S402 below.

Step S401: Obtain a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number.

Specifically, a first floating point number is obtained, where the first floating point number sequentially includes a first sign field, an exponent bit width field (that is, a Dot field), a first exponent field, and a first mantissa field. The exponent bit width field is used for indicating a bit width D occupied by the first exponent field in a total bit width N of the first floating point number. N is an integer greater than 1, and D is an integer greater than or equal to 0.

Optionally, as shown in FIG. 2 and FIG. 3, the first sign field (or referred to as a sign bit) in the first floating point number is located before the Dot field, and occupies 1 bit in the total bit width N of the first floating point number.

Optionally, refer to Table 2 below. Table 2 is a floating point data format according to an embodiment of this application. The technical solution in this embodiment of this application may be specifically implemented based on the floating point data format shown in Table 2.

**Table 2**

| Field (field) | Sign (sign) field | Dot field | Exponent (exponent) field | Mantissa (mantissa) field |
|---|---|---|---|---|
| Width (bit width)/bit | 1 | DW | D | N-1-DW-D |

The following describes in detail each field of the floating point number provided in this embodiment of this application with reference to Table 2.

(1) Sign field: the sign field occupies a bit width of 1 bit, and is used for representing positive and negative data. By default, 0 represents positive, and 1 represents negative. Alternatively, based on an actual requirement, 0 represents negative, and 1 represents positive. This is not specifically limited in this embodiment of this application.

(2) Dot field: the Dot field is a field newly defined on the basis of a standard sign field, a standard exponent field, and a standard mantissa field in this embodiment of this application, and a value (for example, the value may be understood as a coded value) of the Dot field is used for indicating the bit width D occupied by the exponent field in the total bit width N of the floating point number, that is, a value of the Dot field is D. Optionally, a coding manner of the Dot field may be integer coding or prefix coding.

For example, as shown in Table 2 above, a coding manner of the Dot field may be integer coding. In this case, the Dot field occupies a fixed bit width DW in the floating point number, and the mantissa field occupies a bit width (N-1-DW-D) in the floating point number. Therefore, by using simple integer coding, any value among 0 to $2^{DW}-1$ may be coded with the bit width DW occupied by the Dot field, thereby reducing complexity of coding and subsequent decoding and reducing hardware overheads. It may be understood that the value D (that is, the bit width D of the exponent field) is 0 to $2^{DW}-1$. For example, the bit width DW of the Dot field is 3 bits, and the dot may code any value among 0 to 7, that is, the bit width of the exponent field that may be indicated by the Dot field is 0 to 7 bits. For another example, the bit width DW of the Dot field is 5 bits, and the dot may code any value among 0 to 31, that is, the bit width of the exponent field that may be indicated by the Dot field is 0 to 31 bits.

For example, as shown in Table 3 below, a coding manner of the Dot field may be prefix coding. In this case, the bit width occupied by the Dot field in the floating point number is a set of finite values, which may include, for example, a DW1 and a DW2 shown in Table 3, or may further include DW3, DW4, and the like. This is not specifically limited in this embodiment of this application.

**Table 3**

| Field (field) | Sign (sign) field | Dot field | Exponent (exponent) field | Mantissa (mantissa) field |
|---|---|---|---|---|
| Width (bit width)/bit | 1 | DW1 | D | N-1-DW1-D |
| | 1 | DW2 | D | N-1-DW2-D |

As shown in Table 3 above, under the condition that the prefix coding is used, when a bit width of the Dot field is DW1, a bit width of the mantissa field is (N-1-DW1-D) bits; or when a bit width of the Dot field is DW2, a bit width of the mantissa field is (N-1-DW2-D) bits. DW1 and DW2 are integers greater than or equal to 1.

The prefix coding may include conventional prefix coding and unconventional prefix coding. Hereinafter, DW1 is less than DW2 as an example to describe conventional prefix coding and unconventional prefix coding separately.

a. Conventional prefix coding: any one of K1 values is coded with the bit width DW1 occupied by the Dot field; or any one of K2 values is coded with the bit width DW2 occupied by the Dot field. A maximum value of the K1 values is less than a minimum value of the K2 values. Correspondingly, the bit width D of the exponent field belongs to the K1 values or the K2 values. K1 and K2 are integers greater than or equal to 1.

b. Unconventional prefix coding: any one of P1 values is coded with the bit width DW1 occupied by the Dot field; or any one of P2 values is coded with the bit width DW2 occupied by the Dot field. A minimum value of the P1 values is greater than a maximum value of the K2 values. Correspondingly, the bit width D of the exponent field belongs to the P1 values or the P2 values. P1 and P2 are integers greater than or equal to 1.

In conclusion, the conventional prefix coding codes smaller data with a shorter bit width, and codes larger data with a longer bit width. The conventional prefix coding may effectively increase a bit width of a mantissa field of a value near an exponent center, that is, improve precision of a value near an exponent center. The unconventional prefix coding is opposite. The unconventional prefix coding codes larger data with a shorter bit width, and codes smaller data with a longer bit width. The unconventional prefix coding may smooth step change of the bit width of the mantissa field of the value near the exponent center, that is, smooth a precision hop of the value near the exponent center. A user or a worker may select, according to an actual requirement, the conventional prefix coding manner or the unconventional prefix coding manner to code the Dot field. This is not specifically limited in this embodiment of this application.

(3) Exponent field: the exponent field occupies a bit width of D bits in the floating point number. Optionally, the exponent field corresponds to a numerical range E during coding, and a decoded value Ei of the exponent field belongs to the numerical range E. The numerical range E satisfies the following formula (1):

$$E=(-1)^{Se}\times[2^{D-1}, (2^D-1) \tag{1}$$

Se is a sign bit of Ei, and may also be referred to as an exponent sign bit of the exponent field. Se occupies 1 bit in the bit width D of the exponent field, and is used for representing a positive or negative value of the exponent field. By default, Se 0 represents positive, and Se 1 represents negative. Alternatively, according to an actual requirement, 0 represents negative, and 1 represents positive. This is not specifically limited in this embodiment of this application. It should be noted that, from the formula (1) corresponding to the foregoing numerical range E, obviously, except the exponent sign bit Se used for representing positive or negative, a most significant bit of each (binary) value in the numerical range E is 1. For example, Se=0, D=3, and the numerical range E is 100 to 111. For another example, Se=0, D=4, and the numerical range E is 1000 to 1111. For another example, Se=1, D=6, and the numerical range E is -100000 to -111111. Therefore, each bit in the bit width D occupied by the exponent field may not be wasted, more storage space is saved, and data storage or data transfer costs of the floating point number are reduced. Alternatively, when there is a higher requirement for precision, more bit widths may be reserved for the mantissa field without additionally increasing the total bit width of the floating point number, to meet the higher requirement for precision.

Optionally, when D=0, Ei=0.

Optionally, when D is not equal to 0, the exponent field may employ a coding manner that the exponent sign bit Se follows an amplitude TF (that is, signed magnitude (signed data) coding), which is specifically as follows: Optionally, when D=1, a value Es of the exponent field in the floating point number (for example, the first exponent field in the first floating point number) is {Se}, and a decoded value of the exponent field, for example, a value Ei of a second exponent field in normalized data obtained by subsequent decoding, is {Se, 1'b1 }, where 1'b1 is a most significant bit in the TF. As described above, due to a limitation on a coded numerical range of the exponent field in different bit widths D, the most significant bit in the TF is always 1 (that is, 1'b1). Therefore, the most significant bit 1'b1 may not occupy the bit width of the exponent field in the floating point number (that is, 1'b1 is not stored), so that the bit width D of the exponent field includes only the exponent sign bit Se and other bits in the TF except the most significant bit 1'b1, thereby saving storage space and reducing data storage and data transfer costs of the floating point number. It should be understood that, based on the coding rule, the most significant bit 1'b1 may be directly supplemented to the TF during subsequent decoding, to quickly and accurately obtain a decoded value Ei of the exponent field.

Optionally, when D is greater than 1, a value Es of the exponent field in the floating point number (for example, the first exponent field in the first floating point number) is { Se, TF[2:D]}, and a decoded value of the exponent field, for example, a value Ei of a second exponent field in normalized data obtained by subsequent decoding, is {Se, 1'b1, TF[2:D]}. Similarly, 1'b1 is the most significant bit in the TF, and does not occupy a bit width during storage. TF[2:D] includes remaining bits in the TF except the most significant bit 1'b1, and a bit width occupied by the TF[2:D] in the exponent field is D-1.

(4) Mantissa field: as shown in Table 2 and Table 3 above, when the Dot field uses integer coding, a bit width occupied by the mantissa field in the floating point number is (N-1-DW-D) bits; or when the Dot field uses prefix coding, a bit width occupied by the mantissa field in the floating point number is (N-1-DW1-D) bits or (N-1-DW2-D) bits. It is emphasized again that the mantissa field in the floating point number is used for storing a value after a decimal point, for example, storing 10011 in 1.10011, but a value actually represented by the mantissa field in the floating point number, that is, a decoded value M of the mantissa field, is 0.10011.

Step S402: Obtain normalized data corresponding to the first floating point number based on the first sign field, the exponent bit width field, the first exponent field, and the first mantissa field, where the normalized data includes a second sign field, a second exponent field, and a second mantissa field.

Specifically, based on the bit width D indicated by the Dot field, the first exponent field and the first mantissa field are quickly extracted from the first floating point number, and are decoded to obtain the second exponent field and the second mantissa field in the normalized data. Optionally, the second sign field, the second exponent field, and the second mantissa field may satisfy a binary scientific notation. Optionally, a truth value of the normalized data satisfies the following formula (2):

$$X=(-1)^{S}\times 2^{Ei+Ec}\times(1+M) \hspace{4cm} (2)$$

X is normalized data corresponding to the floating point number; S is a value (0 or 1) of the sign field; and Ec is a preset exponent center (which is generally 0, or may be set to a value such as -2, 2, or 3 according to an actual requirement). Ei+Ec=Ev, where Ev represents a carry digit of a decimal point. For example, a total bit width N of a floating point number is 16 bits, and an exponent center Ec is 0. For a decimal value such as 9.25, a binary value of the decimal value is 1001.01, and a truth value of normalized data is $X=(-1)^0\times 2^3\times 1.00101$, where S=0, Ev=Ei+Ec=3, and Ei=3; and a corresponding floating point number may be 1100010010100000, where a most significant bit "1" is a sign field, $2^{nd}$ to $3^{rd}$ bits "10" is a value of a Dot field, $4^{th}$ to $6^{th}$ bits "001" is a value Es (which may be understood as, for example, a coded value of an exponent field) of an exponent field (for example, the first exponent field) in the floating point number, a value Ei (which may be understood as, for example, a decoded value of an exponent field) of an exponent field in normalized data is "0101" (to supplement the hidden most significant bit 1'b1), and remaining $7^{th}$ to $16^{th}$ bits "0010100000" is a value of a mantissa field in the floating point number. It may be understood that, when there is a remaining bit width of the mantissa field, the remaining bit width may be supplemented with 0.

In conclusion, in this embodiment of this application, the bit width D of the exponent field may be indicated by a defined Dot field, which eliminates a constraint on a fixed bit width of each field in a conventional floating point number, and resolves a problem that it is hard to strike a tradeoff between a numerical range, numerical precision, and a total bit width of the conventional floating point number, thereby flexibly meeting different requirements for a numerical range and precision of a floating point number in various scenarios without additionally increasing a total bit width, that is, without increasing data storage or data transfer costs. In addition, based on the bit width D indicated by the Dot field, values of the exponent field and the mantissa field in the floating point number are quickly read, to efficiently and accurately obtain normalized data corresponding to the floating point number, thereby greatly improving efficiency of decoding the floating point number, and further improving overall computing efficiency based on the floating point number in high performance computing HPC or AI training.

Further, the following describes in detail, by using specific examples, the floating point data format provided in embodiments of this application and a method for using the floating point data format. First, it should be noted that all floating point numbers (for example, the foregoing first floating point number) provided in embodiments of this application may be uniformly coded by HiFloat (N, Emw, Ec), which may be abbreviated as HiFN. N represents a total bit width of a floating point number, Emw is a maximum value of a bit width of an exponent to be coded (including a most significant bit 1'b1), and Ec is a preset exponent symmetry center (that is, an exponent center), or is referred to as an exponent bias (bias).

Example 1: HiFloat (N, 16, Ec)

A coding manner of HiFloat (N, 16, Ec) is shown in Table 4, where a sign field occupies 1 bit; a Dot field occupies 4 bits, and may be used for representing 16 pieces of different information (that is, D=[0:15]); a bit width of an exponent field dynamically changes according to a value (D) of the Dot field, and a remaining bit width (N-1-4-D) in a total bit width N is reserved for a mantissa field.

**Table 4**

| Field (field) | Sign (sign) field | Dot field | Exponent (exponent) field | Mantissa (mantissa) field |
|---|---|---|---|---|
| Width (bit width)/bit | 1 | 4 | D | N-1-4-D |

Further, distribution of coded values of the exponent field of HiFloat (N, 16, Ec) is shown in Table 5 below.

## Table 5

| | D | | | | | | | |
|---|---|---|---|---|---|---|---|---|
| | 0 | 1 | 2 | 3 | 4 | 5 | 6 | 7 |
| Es | None | Se | Se,TF[2] | Se,TF[2:3] | Se,TF[2:4] | Se,TF[2:5] | Se,TF[2:6] | Se,TF[2:7] |
| Ei | 0 | Se,1 | Se,1,TF[2] | Se,1,TF[2:3] | Se,1,TF[2:4] | Se,1,TF[2:5] | Se,1,TF[2:6] | Se,1,TF[2:7] |
| Numerical range of Ei | 0 | $\pm 1$ | $\pm[2,3]$ | $\pm[4,7]$ | $\pm[8,15]$ | $\pm[16,31]$ | $\pm[32,63]$ | $\pm[64,127]$ |
| Ev | 0+Ec | {Se,1}+Ec | {Se,1,TF[2]}+Ec | {Se,1,TF[2:3]}+Ec | {Se,1,TF[2:4]}+Ec | {Se,1,TF[2:5]}+Ec | {Se,1,TF[2:6]}+Ec | {Se,1,TF[2:7]}+Ec |
| Numerical range of Ev | 0+Ec | $\pm 1$+Ec | $\pm[2,3]$+Ec | $\pm[4,7]$+Ec | $\pm[8,15]$+Ec | $\pm[16,31]$+Ec | $\pm[32,63]$+Ec | $\pm[64,127]$+Ec |
| Bit width of mantissa field | N–5 | N–6 | N–7 | N–8 | N–9 | N–10 | N–11 | N–12 |

| | D | | | | | | | |
|---|---|---|---|---|---|---|---|---|
| | 8 | 9 | 10 | 11 | 12 | 13 | 14 | 15 |
| Es | Se,TF[2:8] | Se,TF[2:9] | Se,TF[2:10] | Se,TF[2:11] | Se,TF[2:12] | Se,TF[2:13] | Se,TF[2:14] | Se,TF[2:15] |
| Ei | Se,1,TF[2:8] | Se,1,TF[2:9] | Se,1,TF[2:10] | Se,1,TF[2:11] | Se,1,TF[2:12] | Se,1,TF[2:13] | Se,1,TF[2:14] | Se,1,TF[2:15] |
| Numerical range of Ei | $\pm[128,255]$ | $\pm[256,511]$ | $\pm[512,1023]$ | $\pm[1024,2047]$ | $\pm[2048,4095]$ | $\pm[4096,8191]$ | $\pm[8192,16383]$ | $\pm[16384,32767]$ |
| Ev | {Se,1,TF[2:8]}+Ec | {Se,1,TF[2:9]}+Ec | {Se,1,TF[2:10]}+Ec | {Se,1,TF[2:11]}+Ec | {Se,1,TF[2:12]}+Ec | {Se,1,TF[2:13]}+Ec | {Se,1,TF[2:14]}+Ec | {Se,1,TF[2:15]}+Ec |
| Numerical range of Ev | $\pm[128,255]$+Ec | $\pm[256,511]$+Ec | $\pm[512,1023]$+Ec | $\pm[1024,2047]$+Ec | $\pm[2048,4095]$+Ec | $\pm[4096,8191]$+Ec | $\pm[8192,16383]$+Ec | $\pm[16384,32767]$+Ec |
| Bit width of mantissa field | N–13 | N–14 | N–15 | N–16 | N–17 | N–18 | N–19 | N–20 |

As shown in Table 5 above, values of HiFloat (N, 16, Ec) are specifically as follows:

(1) A value of a Dot field is D=[0:15]. In the first example, the Dot field is coded by using an integer. Any value among 0 to 15 is coded by using a bit width of 4 bits, to indicate that the bit width D occupied by an exponent field may be between 0 and 15 bits. Correspondingly, a bit width of a mantissa field also dynamically changes with the value D of the Dot field. As shown in Table 5 above, when D=2, the bit width of the mantissa field is N-1-4-2=N-7; when D=4, the bit width of the mantissa field is N-9; when D=7, the bit width of the mantissa field is N-12, and so on. Apparently, when the bit width of the exponent field is smaller (that is, a numerical range is smaller), the bit width occupied by the mantissa field is larger, and numerical precision is higher. When the bit width of the exponent field is larger (that is, a numerical range is larger), the bit width occupied by the mantissa field is smaller, and numerical precision is lower. Therefore, the floating point number HiFloat provided in this embodiment of this application has a cone precision feature.

(2) Coded value Es of the exponent field: when D=0, Es=0; when D=1, Es={Se}; and when D>1, Es={Se, TF[2:end]}. Apparently, the most significant bit 1'b1 in the TF is hidden and not stored. TF[2:end] includes other bits in the TF except the most significant bit, that is, includes the second bit to a last bit. As shown in Table 5, a value of end is D currently corresponding to the exponent field. Therefore, TF[2:end] may also be written as TF[2:D], indicating that the second bit to the $D^{th}$ bit in the TF are included. For example, as shown in Table 5 above, when D=2, Es={Se, TF[2]}; when D=3, Es={Se, TF[2:3]}; when D=6, Es={Se, TF[2:6]}; when D=14, Es={Se, TF[2:14]}, and so on.

(3) Es is parsed to obtain a decoded value Ei of the exponent field: when D=0, Ei=0; when D=1, Ei={Se, 1'b1}; and when D>1, Ei={Se, 1'b1, TF[2:end]}. As shown in Table 5 above, based on the bit width D indicated by the Dot field, a numerical range of Ei is $\pm[2^{D-1}, 2^D-1]$. For example, when D=3, a numerical range of Ei is $\pm[4, 7]$; when D=5, a numerical range of Ei is $\pm[16, 31]$; when D=11, a numerical range of Ei is $\pm[1024, 2047]$; when D=13, a numerical range of Ei is $\pm[4096, 8191]$, and so on.

(4) Ev=Ei+Ec. Correspondingly, a numerical range of Ev is $\pm[2^{D-1}, 2^D-1]+Ec$. For example, when D=3, a numerical range of Ei is $\pm[4, 7]+Ec$; when D=4, a numerical range of Ei is $\pm[8,15]+Ec$; when D=6, a numerical range of Ei is $\pm[32, 63]+Ec$; when D=8, a numerical range of Ei is $\pm[128, 255]+Ec$, and so on.

(5) A truth value after HiFloat (N, 16, Ec) is normalized is $X=(-1)^S\times2^{Ei+Ec}\times(1+M)$.

Optionally, HiFloat (N, 16, Ec) may be specifically configured as HiFloat (64, 16, 0) with a total bit width N=64 and an exponent center Ec=0, abbreviated as HiF64. Alternatively, HiFloat (N, 16, Ec) may be configured as HiFloat (128, 16, 0) with a total bit width N=128 and an exponent center Ec=0, abbreviated as HiF128. Alternatively, HiFloat (N, 16, Ec) may be configured as any other possible case based on an actual requirement, for example, HiFloat (64, 16, -2) and HiFloat (32, 16, 0). This is not specifically limited in this embodiment of this application.

Refer to FIG. 5. FIG. 5 is a schematic diagram of mantissa-exponent distribution of a HiF64 according to an embodiment of this application. It may be understood that, because HiF64 exponents cover a very large range (for example, $\pm[16384, 32767]$ shown in Table 5), FIG. 5 shows only a part of the exponent range. As shown in FIG. 5, taking HiFloat (64, 16, 0) as an example, a smaller absolute value of an exponent indicates a larger bit width of a mantissa field, and HiFloat (64, 16, 0) has a relatively obvious tapered precision feature, can provide maximum precision of a 59-bit mantissa (when D=0), and also has a larger numerical range. The HiF64 may be used in the fields of general-purpose computing, HPC, and the like, and may effectively resolve a problem that precision and a numerical range in an existing FP64 are insufficient for some applications.

Optionally, in some possible implementations, in addition to the foregoing normal representation, a value X represented by a floating point number may also selectively represent various special values through a customized setting. For details, refer to Table 6 below.

(1) When an exponent field (for example, the first exponent field in the first floating point number) is all 1s, and a mantissa field (for example, the first mantissa field in the first floating point number) is all 0s, a sign field (for example, the first sign field in the first floating point number) is 0 or 1, and a floating point number is $\pm0$.

HiFloat (64, 16, 0) is used as an example. As shown in Table 6 below, when D=15, 15 bits occupied by an exponent field are all 1s (Es=15'b1111, 1111, 1111, 111), and 44 bits of a mantissa field are all 0s (M=44' b 0000, 0000, 0000, 0000, 0000, 0000, 0000, 0000, 0000, 0000, 0000), if a current sign field is 0, a floating point number may be represented as +0, or if a current sign field is 1, a floating point number may be represented as -0; alternatively, if a current sign field is 0, a floating point number may be represented as -0, or if a current sign field is 1, a floating point number may be represented as $\pm0$.

(2) When an exponent field is all 1s and a mantissa field is not 0, a sign field is 0 or 1, and a floating point number may be represented as a subnormal value (Subnormal). That a mantissa field is not 0 means that at least one digit in the mantissa field is 1.

HiFloat (64, 16, 0) is still used as an example. As shown in Table 6 below, when D=15, 15 bits occupied by an exponent field are all 1s (Es=15'b1111, 1111, 1111, 111), and 44 bits of a mantissa field are not all 0s (for example, M=44' b 0001, 0011, 0000, 0000, 0000, 0000, 0000, 0000, 0000, 0000, 0000; for another example, M=44' b 0001, 0000, 0000, 0000, 0000, 0000, 0000, 0000, 0000, 0000, 0000), a sign field is 0 or 1, and a floating point number may be represented as a subnormal value (subnormal number), which is alternatively referred to as a non-specification value. It should be explained that a number, an integer part of which is 0 and which has a hidden mantissa digit, is referred to as a subnormal number. The subnormal number may be understood as "a number less than a normal number". The concept of subnormal number is introduced to reduce precision bit by bit when floating point number underflow occurs, to express a minimum number near 0 as accurately as possible.

(3) When Se of an exponent field is 0, TF is all 1s, and a mantissa field is all 0s, a sign field is 0 or 1, and a floating point number may be represented as positive or negative infinity.

HiFloat (64, 16, 0) is still used as an example. As shown in Table 6 below, when D=15, Se in an exponent field is 0, TF is all 1s (that is, Es=15'b0111, 1111, 1111, 111), and 44 bits in a mantissa field are all 0s (M=44' b 0000, 0000, 0000, 0000, 0000, 0000, 0000, 0000, 0000, 0000, 0000), if a current sign field is 0, a floating point number may be represented as + infinity (infinity), or if a current sign field is 1, a floating point number may be represented as - infinity; alternatively, if a current sign field is 0, a floating point number may be represented as - infinity, or if a current sign field is 1, a floating point number may be represented as + infinity.

(4) When Se of an exponent field is 0, TF is all 1s, and a mantissa field is not 0, a sign field is 0 or 1, and a floating point number may be represented as not a number (not a number, NaN). NaN is a special value, which is applicable to a case where no value is returned for an operand to be returned. For example, in other programming languages, dividing any value by 0 will cause an error and stop code execution accordingly. However, in javascript, dividing any value by 0 will return NaN. Therefore, execution of other codes is not affected.

HiFloat (64, 16, 0) is still used as an example. As shown in Table 6 below, when D=15, Se in an exponent field is 0, TF is all 1s (that is, Es=15'b0111, 1111, 1111, 111), and 44 bits of a mantissa field are not all 0s (for example, M=44' b 1001, 1000, 0000, 0000, 0000, 0000, 0000, 0000, 0000, 0000, 0000; for another example, M=44' b 1000, 1000, 0000, 0000, 0000, 0000, 0000, 0000, 0000, 0000, 0000), a sign field is 0 or 1, a floating point number may be represented as not a number (not a number, NaN).

**Table 6**

| D | Exponent field | Mantissa field | Value represented by floating point number | Equation (equation) |
|---|---|---|---|---|
| 15 | 15'b1111, 1111, 1111, 111 | M=0 | $\pm 0$ | $(-1)^S \times 2^{-32767+Ec} \times 0.M$ |
| | | M≠0 | Subnormal value (Subnormal) | |
| 15 | 15'b0111,1111,1111,111 | M=0 | $\pm$ infinity (infinity) | ------ |
| | | M≠0 | NaN | |

Example 2: HiFloat (N, 8, Ec)

A coding manner of HiFloat (N, 8, Ec) is shown in Table 7, where a sign field occupies 1 bit; a Dot field occupies 3 bits, and may be used for representing 8 pieces of different information (that is, D=[0:7]); a bit width of an exponent field dynamically changes according to a value (D) of the Dot field, and a remaining bit width (N-1-3-D) in a total bit width N is reserved for a mantissa field.

**Table 7**

| Field (field) | Sign (sign) field | Dot field | Exponent (exponent) field | Mantissa (mantissa) field |
|---|---|---|---|---|
| Width (bit width)/bit | 1 | 3 | D | N-1-3-D |

Further, distribution of coded values of the exponent field of HiFloat (N, 8, Ec) is shown in Table 8 below.

**Table 8**

| | D | | | | | | | |
|---|---|---|---|---|---|---|---|---|
| | 0 | 1 | 2 | 3 | 4 | 5 | 6 | 7 |
| Es | None | Se | Se,TF[2] | Se,TF[2:3] | Se,TF[2:4] | Se,TF[2:5] | Se,TF[2:6] | Se,TF[2:7] |

(continued)

| | D | | | | | | | |
|---|---|---|---|---|---|---|---|---|
| | 0 | 1 | 2 | 3 | 4 | 5 | 6 | 7 |
| Ei | 0 | Se,1 | Se,1,TF[2] | Se,1,TF[2:3] | Se,1,TF[2:4] | Se,1,TF[2:5] | Se,1,TF[2:6] | Se,1,TF[2:7] |
| Numer ical range of Ei | 0 | $\pm 1$ | $\pm[2,3]$ | $\pm[4,7]$ | $\pm[8,15]$ | $\pm[16,31]$ | $\pm[32,63]$ | $\pm[64,127]$ |
| Ev | 0+Ec | {Se,1}+Ec | {Se,1,TF[2]}+Ec | {Se,1,TF[2:3]}+Ec | {Se,1,TF[2:4]}+Ec | {Se,1,TF[2:5]}+Ec | {Se,1,TF[2:6]}+Ec | {Se,1,TF[2:7]}+Ec |
| Numer ical range of Ev | 0+Ec | $\pm 1$+Ec | $\pm[2,3]$+Ec | $\pm[4,7]$+Ec | $\pm[8,15]$+Ec | $\pm[16,31]$+Ec | $\pm[32,63]$+Ec | $\pm[64,127]$+Ec |
| Bit width of mantis sa field | N-4 | N-5 | N-6 | N-7 | N-8 | N-9 | N-10 | N-11 |

As shown in Table 8, values of HiFloat (N, 8, Ec) are specifically as follows:

(1) A value of a Dot field is D=[0:7]. In the second example, the Dot field is coded by using an integer. Any value among 0 to 7 is coded by using a bit width of 3 bits, to indicate that a bit width D occupied by an exponent field may be between 0 and 7 bits. Correspondingly, a bit width of a mantissa field also dynamically changes with the value D of the Dot field. As shown in Table 8 above, when D=2, the bit width of the mantissa field is N-1-3-2=N-6; when D=4, the bit width of the mantissa field is N-8; when D=6, the bit width of the mantissa field is N-10, and so on. Similarly, when the bit width of the exponent field is smaller (that is, a numerical range is smaller), the bit width occupied by the mantissa field is larger, and numerical precision is higher. When the bit width of the exponent field is larger (that is, a numerical range is larger), the bit width occupied by the mantissa field is smaller, and numerical precision is lower. That is, HiFloat (N, 8, Ec) has a tapered precision feature.

(2) Coded value Es of the exponent field: when D=0, Es=0; when D=1, Es={Se}; and when D>1, Es={Se, TF[2:end]}. For example, as shown in Table 8 above, when D=5, Es={ Se, TF[2:5]}; when D=6, Es={Se, TF[2:6]}, and so on.

(3) Es is parsed to obtain a decoded value Ei of the exponent field: when D=0, Ei=0; when D=1, Ei={Se, 1'b1}; and when D>1, Ei={Se, 1'b1, TF[2:end]}. As shown in Table 8 above, based on the bit width D indicated by the Dot field, a numerical range of Ei is $\pm[2^{D-1}, 2^D-1]$. For example, when D=3, a numerical range of Ei is $\pm[4,7]$; when D=5, a numerical range of Ei is $\pm[16,31]$, and so on.

(4) Ev=Ei+Ec. Correspondingly, a numerical range of Ev is $\pm[2^{D-1}, 2^D-1]$+Ec. For example, as shown in Table 8 above, when D=3, a numerical range of Ei is $\pm[4,7]$+Ec; when D=4, a numerical range of Ei is $\pm[8,15]$+Ec; when D=6, a numerical range of Ei is $\pm[32,63]$+Ec, and so on.

(5) A truth value after HiFloat (N, 8, Ec) is normalized is $X=(-1)^S \times 2^{Ei+Ec} \times (1+M)$.

Optionally, HiFloat (N, 8, Ec) may be specifically configured as HiFloat (32, 8, 0) with a total bit width N=32 and an exponent center Ec=0, abbreviated as HiF32. Alternatively, HiFloat (N, 8, Ec) may be configured as HiFloat (16, 8, 0) with a total bit width N=16 and an exponent center Ec=0, abbreviated as HiF16. Alternatively, HiFloat (N, 8, Ec) may be configured as any other possible case based on an actual requirement, for example, HiFloat (32, 8, 2). This is not specifically limited in this embodiment of this application.

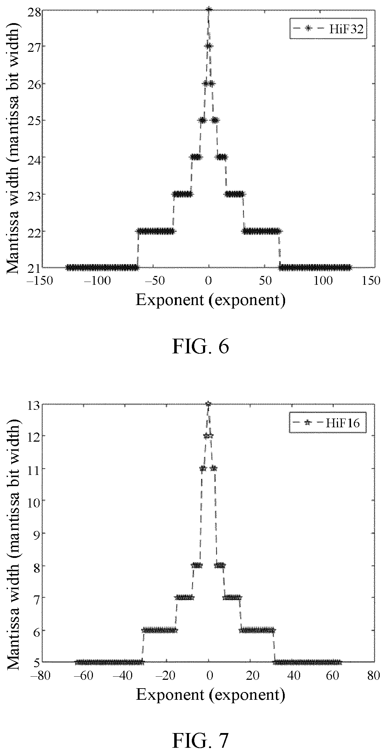

Refer to FIG. 6. FIG. 6 is a schematic diagram of mantissa-exponent distribution of a HiF32 according to an embodiment of this application. As shown in FIG. 6, HiFloat (32, 8, 0) as an example has a relatively obvious tapered precision feature, and can provide maximum precision of a 28-bit mantissa (when D=0). The HiF32 may be used in the fields of general-purpose computing, HPC, and the like, and may effectively resolve a problem that precision and a numerical range in an existing FP32 are insufficient for some applications.

Optionally, HiFloat (N, 8, Ec) may also selectively represent various special values. For details, refer to Table 9 below.

(1) When an exponent field is all 1s and a mantissa field is all 0s, a sign field is 0 or 1, and a floating point number is ±0.

HiFloat (32, 8, 0) is used as an example. As shown in Table 9 below, when D=7, 7 bits occupied by an exponent field are all 1s (Es=7'b1111, 111), and 21 bits of a mantissa field are all 0s (M=21'b 0000, 0000, 0000, 0000, 0000, 0), if a current sign field is 0, a floating point number may be represented as +0, or if a current sign field is 1, a floating point number may be represented as -0; alternatively, if a current sign field is 0, a floating point number may be represented as -0, or if a current sign field is 1, a floating point number may be represented as +0.

(2) When an exponent field is all 1s and a mantissa field is not 0, a sign field is 0 or 1, and a floating point number may be represented as a subnormal value.

HiFloat (32, 8, 0) is still used as an example. As shown in Table 9 below, when D=7, 7 bits occupied by an exponent field are all 1s (Es=7'b1111, 111), and 21 bits of a mantissa field are not all 0s (for example, M=21'b 0001, 0011, 0000, 0000, 0000, 0; for another example, M=21'b 0001, 0000, 0000, 0000, 0000, 0), a sign field is 0 or 1, and a floating point number may be represented as a subnormal value.

(3) When Se of an exponent field is 0, TF is all 1s, and a mantissa field is all 0s, a sign field is 0 or 1, and a floating point number may be represented as positive or negative infinity.

HiFloat (32, 8, 0) is still used as an example. As shown in Table 9 below, when D=7, Se in an exponent field is 0, TF is all 1s (that is, Es=7'b0111, 111), and 21 bits in a mantissa field are all 0s (M=21'b 0000, 0000, 0000, 0000, 0000, 0), if a current sign field is 0, a floating point number may be represented as + infinity (infinity), or if a current sign field is 1, a floating point number may be represented as - infinity; alternatively, if a current sign field is 0, a floating point number may be represented as - infinity, or if a current sign field is 1, a floating point number may be represented as + infinity.

(4) When Se of an exponent field is 0, TF is all 1s, and a mantissa field is not 0, a sign field is 0 or 1, and a floating point number may be represented as NaN.

HiFloat (32, 8, 0) is still used as an example. As shown in Table 9 below, when D=7, Se in an exponent field is 0, TF is all 1s (that is, Es=7'b0111, 111), and 44 bits of a mantissa field are not all 0s (for example, M=21'b 1001, 1000, 0000, 0000, 0000, 0; for another example, M=21'b 1000, 0000, 0000, 0000, 0000, 0), a sign field is 0 or 1, and a floating point number may be represented as NaN.

**Table 9**

| D | Exponent field | Mantissa field | Value represented by floating point number | Equation (equation) |
|---|---|---|---|---|
| 7 | 7'b1111, 111 | M=0 | ±0 | $(-1)^S \times 2^{-127+Ec} \times 0.M$ |
| | | M≠0 | Subnormal value (Subnormal) | |
| 7 | 7'b0111, 111 | M=0 | ± infinity (infinity) | ------- |
| | | M≠0 | NaN | |

Example 3: HiFloat (N, 7, Ec)

A coding manner of HiFloat (N, 7, Ec) is shown in Table 10, where a sign field occupies 1 bit; a Dot field employs conventional prefix coding, occupies 2 bits or 4 bits, and may be used for representing 7 pieces of different information in total (that is, D=[0:6]); a bit width of an exponent field dynamically changes according to a value (D) of the Dot field, and a remaining bit width (N-1-2-D) or (N-1-4-D) in a total bit width N is reserved for a mantissa field.

**Table 10**

| Field (field) | Sign (sign) field | Dot field | Exponent (exponent) field | Mantissa (mantissa) field |
|---|---|---|---|---|
| Width (bit width)/bit | 1 | 2:{0, 1, 2} | D | N-1-2-D |
| | 1 | 4:{3, 4, 5, 6} | D | N-1-4-D |

As shown in Table 10 above, the Dot field in the HiFloat (N, 7, Ec) employs conventional prefix coding, where values 0, 1, and 2 are coded with a bit width of 2 bits, and values 3, 4, 5, and 6 are coded with a bit width of 4 bits. Optionally, refer to Table 11 below. Table 11 is a coding example. When a bit width of a Dot field is 2 bits, a value 0 may be coded with "00", a value 1 may be coded with "01", and a value 2 may be coded with "10"; and when a bit width of a Dot field is 4 bits, a value 3 may be coded with "11, 00", a value 4 may be coded with "11, 01", a value 5 may be coded with "11, 10", and a value 6 may be coded with "11, 11". It should be understood that Table 11 is merely an example for description. In some possible embodiments, different coding correspondences may be used. For example, a value 3 may be coded with "11, 01", a value 4 may be coded with "11, 00", a value 5 may be coded with "11, 11", and a value 6 may be coded with "11, 10". This is not specifically limited in this embodiment of this application.

**Table 11**

| Width (bit width) of Dot field/bit | Coding (coding) | Value (value) |
|---|---|---|
| 2 | 00 | 0 |
| | 01 | 1 |
| | 10 | 2 |
| 4 | 11, 00 | 3 |
| | 11, 01 | 4 |
| | 11, 10 | 5 |
| | 11, 11 | 6 |

Further, distribution of coded values of the exponent field of HiFloat (N, 7, Ec) is shown in Table 12 below.

**Table 12**

| | D | | | | | | |
|---|---|---|---|---|---|---|---|
| | 0 | 1 | 2 | 3 | 4 | 5 | 6 |
| Es | None | Se | Se,TF[2] | Se,TF[2:3] | Se,TF[2:4] | Se,TF[2:5] | Se,TF[2:6] |
| Ei | 0 | Se,1 | Se,1,TF[2] | Se,1,TF[2:3] | Se,1,TF[2:4] | Se,1,TF[2:5] | Se,1,TF[2:6] |
| Numeric al range of Ei | 0 | $\pm 1$ | $\pm[2,3]$ | $\pm[4,7]$ | $\pm[8,15]$ | $\pm[16,31]$ | $\pm[32,63]$ |
| Ev | 0+Ec | {Se,1}+ Ec | {Se,1,TF[2]}+ Ec | {Se,1,TF[2:3]}+ Ec | {Se,1,TF[2:4] }+ Ec | {Se,1,TF[2:5]}+ Ec | {Se,1,TF[2:6]}+ Ec |
| Numeric al range of Ev | 0+Ec | $\pm 1$+Ec | $\pm[2,3]$+Ec | $\pm[4,7]$+Ec | $\pm[8,15]$+Ec | $\pm[16,31]$+Ec | $\pm[32,63]$+Ec |
| Bit width of mantissa field | N-3 | N-4 | N-5 | N-8 | N-9 | N-10 | N-11 |

As shown in Table 12 above, values of HiFloat (N,7, Ec) are specifically as follows:

(1) A value of a Dot field is D=[0:6]. In the third example, the Dot field employs conventional prefix coding in the prefix coding. Values 0, 1, and 2 are coded with a bit width of 2 bits, and values 3, 4, 5, and 6 are coded with a bit width of 4 bits, indicating that a bit width D occupied by an exponent field may be between 0 and 6 bits. Correspondingly, a bit width of a mantissa field also dynamically changes with the value D of the Dot field. As shown in Table 12 above, when D=2, the bit width of the mantissa field is N-1-2-2=N-5; when D=4, the bit width of the mantissa field is N-1-4-4=N-9; when D=6, the bit width of the mantissa field is N-11, and so on. On this basis, compared with the integer coding used for a Dot field, the conventional prefix coding may change the bit width of the mantissa field more obviously, that is, the bit width of the mantissa field greatly decreases as the bit width of the Dot field and the bit width of the exponent field increase synchronously, thereby effectively improving precision of a value near the exponent center.

(2) Coded value Es of the exponent field: when D=0, Es=0; when D=1, Es={Se}; and when D>1, Es={Se, TF[2:end]}. For example, as shown in Table 12 above, when D=2, Es={Se, TF[2]}; when D=6, Es={Se, TF[2:6]}, and so on.

(3) Es is parsed to obtain a decoded value Ei of the exponent field: when D=0, Ei=0; when D=1, Ei={Se, 1'b1}; and when D>1, Ei={Se, 1'b1, TF[2:end]}. As shown in Table 12 above, based on the bit width D indicated by the Dot field, a numerical range of Ei is $\pm[2^{D-1}, 2^D-1]$. For example, when D=3, a numerical range of Ei is $\pm[4,7]$; when D=5, a numerical range of Ei is $\pm[16,31]$, and so on.

(4) Ev=Ei+Ec. Correspondingly, a numerical range of Ev is $\pm[2^{D-1}, 2^D-1]+$Ec. For example, as shown in Table 12 above, when D=3, a numerical range of Ei is $\pm[4,7]+$Ec; when D=4, a numerical range of Ei is $\pm[8,15]+$Ec; when D=6, a numerical range of Ei is $\pm[32,63]+$Ec, and so on.

(5) A truth value after HiFloat (N, 7, Ec) is normalized is $X=(-1)^S \times 2^{Ei+Ec} \times (1+M)$.

Optionally, HiFloat (N, 7, Ec) may be configured as HiFloat (16, 7, 0) with a total bit width N=16 and an exponent center Ec=0, abbreviated as HiF16. Alternatively, HiFloat (N, 7, Ec) may be configured as any other possible case based on an actual requirement, for example, HiFloat (16, 7, 2). This is not specifically limited in this embodiment of this application.

Refer to FIG. 7. FIG. 7 is a schematic diagram of mantissa-exponent distribution of a HiF16 according to an embodiment of this application. As shown in FIG. 7, HiFloat (16, 7, 0) as an example has a relatively obvious tapered precision feature, and numerical precision near an exponent center is obviously higher than that away from the exponent center. As shown in FIG. 7, the HiF16 can provide maximum precision of a 13 -bit mantissa (when D=0), and has a larger numerical range. The HiF16 may be used for a vector part in a field of AI machine learning, and may reduce bandwidth and storage requirements of a conventional FP32 by half while ensuring neural network training precision to some extent.

Optionally, HiFloat (N, 7, Ec) may also selectively represent various special values. For details, refer to Table 13 below.

(1) When an exponent field is all 1s and a mantissa field is all 0s, a sign field is 0 or 1, and a floating point number is $\pm 0$.

HiFloat (16, 7, 0) is used as an example. As shown in Table 13 below, when D=6, 6 bits occupied by an exponent field are all 1s (Es=6'b1111, 11), and 5 bits of a mantissa field are all 0s (M=5'b 0000, 0), if a current sign field is 0, a floating point number may be represented as +0, or if a current sign field is 1, a floating point number may be represented as -0; alternatively, if a current sign field is 0, a floating point number may be represented as -0, or if a current sign field is 1, a floating point number may be represented as +0.

(2) When an exponent field is all 1s and a mantissa field is not 0, a sign field is 0 or 1, and a floating point number may be represented as a subnormal value.

HiFloat (16, 7, 0) is still used as an example. As shown in Table 13 below, when D=6, 6 bits occupied by an exponent field are all 1s (Es=6'b1111, 11), and 5 bits of a mantissa field are not all 0s (for example, M=5'b 0001, 0; for another example, M=5'b 1101, 0), a sign field is 0 or 1, and a floating point number may be represented as a subnormal value.

(3) When Se of an exponent field is 0, TF is all 1s, and a mantissa field is all 0s, a sign field is 0 or 1, and a floating point number may be represented as positive or negative infinity.

HiFloat (16, 7, 0) is still used as an example. As shown in Table 13 below, when D=6, Se in an exponent field is 0, TF is all 1s (that is, Es=6'b0111, 11), and 5 bits in a mantissa field are all 0s (M=5'b 0000, 0), if a current sign field is 0, a floating point number may be represented as + infinity (infinity), or if a current sign field is 1, a floating point number may be represented as - infinity; alternatively, if a current sign field is 0, a floating point number may be represented as - infinity, or if a current sign field is 1, a floating point number may be represented as + infinity.

(4) When Se of an exponent field is 0, TF is all 1s, and a mantissa field is not 0, a sign field is 0 or 1, and a floating point number may be represented as NaN.

HiFloat (16, 7, 0) is still used as an example. As shown in Table 13 below, when D=6, Se in an exponent field is 0, TF is all 1s (that is, Es=6'b0111, 11), and 5 bits of a mantissa field are not all 0s (for example, M=5'b 1001, 1; for another example, M=5'b 1000, 0), a sign field is 0 or 1, and a floating point number may be represented as NaN.

**Table 13**

| D | Exponent field | Mantissa field | Value represented by floating point number | Equation (equation) |
|---|---|---|---|---|
| 6 | 6'b1111, 11 | M=0 | $\pm 0$ | $(-1)^S \times 2^{-63+Ec} \times 0.M$ |
| | | M≠0 | Subnormal value (Subnormal) | |

(continued)

| D | Exponent field | Mantissa field | Value represented by floating point number | Equation (equation) |
|---|---|---|---|---|
| 6 | 6'b0111, 11 | M=0 | $\pm$ infinity (infinity) | ------- |
| | | M$\neq$0 | NaN | |

Example 4: HiFloat (N, 5, Ec)

A coding manner of HiFloat (N, 5, Ec) is shown in Table 14 below, where a sign field occupies 1 bit; a Dot field employs unconventional prefix coding, occupies 2 bits or 3 bits, and may be used for representing 5 pieces of different information in total (that is, D=[0:4]); a bit width of an exponent field dynamically changes according to a value (D) of the Dot field, and a remaining bit width (N-1-2-D) or (N-1-3-D) in a total bit width N is reserved for a mantissa field.

**Table 14**

| Field (field) | Sign (sign) field | Dot field | Exponent (exponent) field | Mantissa (mantissa) field |
|---|---|---|---|---|
| Width (bit width)/bit | 1 | 2:{2, 3, 4} | D | N-1-2-D |
| | 1 | 3:{0, 1} | D | N-1-3-D |

As shown in Table 14 above, the Dot field in the HiFloat (N, 5, Ec) employs unconventional prefix coding, where values 2, 3, and 4 are coded with a bit width of 2 bits, and values 0 and 1 are coded with a bit width of 3 bits. Optionally, refer to Table 15 below. Table 15 is a coding example. When a bit width of a Dot field is 2 bits, a value 4 may be coded with "11", a value 3 may be coded with "10", and a value 2 may be coded with "01"; and when a bit width of a Dot field is 3 bits, a value 1 may be coded with "00, 1", and a value 6 may be coded with "00, 0". It should be understood that Table 15 is merely an example for description. In some possible embodiments, different coding correspondences may be used. For example, a value 1 may be coded with "11, 1", and a value 0 may be coded with "11, 0". This is not specifically limited in this embodiment of this application.

**Table 15**

| Width (bit width) of Dot field/bit | Coding (coding) | Value (value) |
|---|---|---|
| 2 | 11 | 4 |
| | 10 | 3 |
| | 01 | 2 |
| 3 | 00, 1 | 1 |
| | 00, 0 | 0 |

Further, distribution of coded values of the exponent field of HiFloat (N, 5, Ec) is shown in Table 16 below.

**Table 16**

| | D | | | | |
|---|---|---|---|---|---|
| | 0 | 1 | 2 | 3 | 4 |
| Es | None | Se | Se,TF[2] | Se,TF[2:3] | Se,TF[2:4] |
| Ei | 0 | Se,1 | Se,1,TF[2] | Se,1,TF[2:3] | Se,1,TF[2:4] |
| Numerical range of Ei | 0 | $\pm$1 | $\pm$[2,3] | $\pm$[4,7] | $\pm$[8,15] |
| Ev | 0+Ec | {Se,1}+Ec | {Se,1,TF[2]}+Ec | {Se,1,TF[2:3]}+Ec | {Se,1,TF[2:4]}+Ec |
| Numerical range of Ev | 0+Ec | $\pm$1+Ec | $\pm$[2,3]+Ec | $\pm$[4,7]+Ec | $\pm$[8,15]+Ec |
| Bit width of mantissa field | N-4 | N-5 | N-5 | N-6 | N-7 |

As shown in Table 16 above, values of HiFloat (N, 5, Ec) are specifically as follows:

(1) A value of a Dot field is D=[0:4]. In the fourth example, the Dot field employs unconventional prefix coding in the prefix coding. Values 2, 3, and 4 are coded with a bit width of 2 bits, and values 0 and 1 are coded with a bit width of 3 bits, indicating that a bit width D occupied by an exponent field may be between 0 and 4 bits. Correspondingly, a bit width of a mantissa field also dynamically changes with the value D of the Dot field. As shown in Table 12 above, when D=1, the bit width of the mantissa field is N-1-3-1=N-5; when D=2, the bit width of the mantissa field is N-1-2-2=N-5; when D=4, the bit width of the mantissa field is N-1-2-4=N-7, and so on. On this basis, compared with the integer coding or conventional prefix coding used for a Dot field, the unconventional prefix coding may change the bit width of the mantissa field more smoothly, that is, the bit width of the mantissa field changes smoothly as the bit width of the Dot field increases and the bit width of the exponent field decreases synchronously, so that step change of precision of the floating point number can be effectively smoothed.

(2) Coded value Es of the exponent field: when D=0, Es=0; when D=1, Es={Se}; and when D>1, Es={Se, TF[2:end]}. For example, as shown in Table 16 above, when D=2, Es={Se, TF[2]}; when D=3, Es={Se, TF[2:3]}, and so on.

(3) Es is parsed to obtain a decoded value Ei of the exponent field: when D=0, Ei=0; when D=1, Ei={Se, 1'b1}; and when D>1, Ei={Se, 1'b1, TF[2:end]}. As shown in Table 16 above, based on the bit width D indicated by the Dot field, a numerical range of Ei is $\pm[2^{D-1}, 2^D-1]$. For example, when D=3, a numerical range of Ei is $\pm[4,7]$; when D=4, a numerical range of Ei is $\pm[8,15]$, and so on.

(4) Ev=Ei+Ec. Correspondingly, a numerical range of Ev is $\pm[2^{D-1}, 2^D-1]+Ec$. For example, as shown in Table 16 above, when D=3, a numerical range of Ei is $\pm[4, 7]+Ec$; when D=4, a numerical range of Ei is $\pm[8, 15]+Ec$, and so on.

(5) A truth value after HiFloat (N, 5, Ec) is normalized is $X=(-1)^S \times 2^{Ei+Ec} \times (1+M)$.

Optionally, HiFloat (N, 5, Ec) may be specifically configured as HiFloat (8, 5, 0) with a total bit width N=8 and an exponent center Ec=0, abbreviated as HiF8. Alternatively, HiFloat (N, 5, Ec) may be configured as any other possible case based on an actual requirement, for example, HiFloat (8, 5, 1). This is not specifically limited in this embodiment of this application.

A coding manner of HiFloat (8, 5, 0) may be shown in Table 17 below.

**Table 17**

| Field (field) | Sign (sign) field | Dot field | Exponent (exponent) field | Mantissa (mantissa) field |
|---|---|---|---|---|
| Width (bit width)/bit | 1 | 2:{2, 3, 4} | D | 8-3-D |
| | 1 | 3:{0, 1} | D | 8-4-D |

Correspondingly, distribution of coded values of the exponent field of HiFloat (8, 5, 0) is shown in Table 18 below.

**Table 18**

| | D | | | | |
|---|---|---|---|---|---|
| | 0 | 1 | 2 | 3 | 4 |
| Es | None | Se | Se,TF[2] | Se,TF[2:3] | Se,TF[2:4] |
| Ei | 0 | Se,1 | Se,1,TF[2] | Se,1,TF[2:3] | Se,1,TF[2:4] |
| Numerical range of Ei | 0 | $\pm 1$ | $\pm[2,3]$ | $\pm[4,7]$ | $\pm[8,15]$ |
| Ev | 0+Ec | {Se,1}+Ec | {Se,1,TF[2]}+Ec | {Se,1,TF[2:3]}+Ec | {Se,1,TF[2:4]}+Ec |
| Numerical range of Ev | 0+Ec | $\pm 1$+Ec | $\pm[2,3]$+Ec | $\pm[4,7]$+Ec | $\pm[8,15]$+Ec |
| Bit width of mantissa field | 4 | 3 | 3 | 2 | 1 |

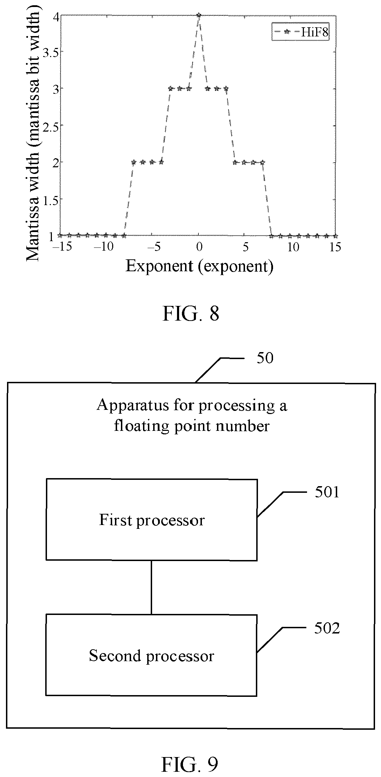

Refer to FIG. 8. FIG. 8 is a schematic diagram of mantissa-exponent distribution of a HiF8 according to an embodiment of this application. As shown in FIG. 8, HiFloat (8, 5, 0) is used as an example. HiF8 has a tapered precision feature, can provide maximum precision of a 4-bit mantissa (when D=0), and has a numerical range almost equivalent to that of FP16. The HiF8 may be used for a tensor part in a field of AI machine learning, and may reduce bandwidth and storage requirements of a conventional FP16 by half while ensuring neural network training or precision to some extent. Optionally, HiFloat (8, 5, 0) may also selectively represent various special values. Details are as follows:

(1) When a sign field S=0, D=4, Es=4'b1111=-15, and M=1'b0, a value X represented by a floating point number is 0.
(2) When a sign field S=1, D=4, Es=4'b1111=-15, and M=1'b1, a value X represented by a floating point number is NaN.

(3) When D=4, Es=4'b0111=15, and M=1'b1, a value X represented by a floating point number is $\pm$infinity.

Therefore, floating point numbers such as HiF64, HiF32, HiF16, and HiF8 may be represented as normalized data through a value of each field therein, and may also be represented as some special values through a customized setting, to meet different requirements in general-purpose computing, high performance computing, and AI training or inference.

In conclusion, in embodiments of this application, a Dot field is introduced to indicate a valid bit width of an exponent field (that is, a bit width D occupied during actual storage of an exponent field), and a HiFloat floating point data format with a tapered precision feature is proposed, so that data in an exponent center has a relatively high mantissa bit width (that is, precision), and precision of data farther away from the exponent center decreases as the mantissa bit width gradually decreases. Therefore, a total bit width, a numerical range, and numerical precision of a floating point number are effectively balanced, and different requirements for numerical ranges and numerical precision of floating point numbers in various scenarios are flexibly met without additional data storage or data transfer costs.

Moreover, in embodiments of this application, a codable numerical range of the exponent field in different bit widths (that is, different values represented by the Dot field) is further limited, which effectively avoids a problem of overlapping of values of the exponent field in different bit widths of the exponent field (for example, value overlapping between 11 and 011 or between 1011 and 001011 is avoided), so that there is no information repetition and no redundant coding in the HiFloat data coding manner. On this basis, a most significant bit 1'b1 of a true form amplitude in the exponent field may be hidden and not stored, thereby further reducing data storage or data transfer costs of a floating point number, and the like.

Furthermore, in embodiments of this application, any one of integer coding, conventional prefix coding, unconventional prefix coding, or the like may be used for the Dot field based on different actual requirements. By using simple integer coding, the Dot field may occupy a smaller bit width, and the exponent and the mantissa may be parsed quickly and conveniently. The conventional prefix coding may effectively increase a bit width of a mantissa field of a value near an exponent center, that is, improve precision of a value near an exponent center. The unconventional prefix coding may smooth step change of the bit width of the mantissa field, that is, smooth step change of numerical precision.

Optionally, each method flow in the method for processing a floating point number as described in embodiments of this application may be specifically implemented based on software, hardware, or a combination thereof. A hardware implementation may include a logic circuit, an algorithm circuit, an analog circuit, or the like. A software implementation may include program instructions, may be considered as a software product stored in a memory, and may be run by a processor to implement a related function.

Further, refer to FIG. 9, FIG. 9 is a schematic diagram of a structure of an apparatus for processing a floating point number according to an embodiment of this application. As shown in FIG. 9, the apparatus for processing a floating point number 50 may include a first processor 501 and a second processor 502. The first processor 501 may be, for example, the decoder 100 in the embodiment shown in FIG. 2, or may be a processor integrated with a decoder. The second processor 502 may be, for example, the encoder 200 in the embodiment shown in FIG. 3, or may be a processor integrated with an encoder. Detailed descriptions of all the units are as follows:

The first processor 501 is configured to: obtain a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; and obtain normalized data corresponding to the first floating point number based on the first sign field, the exponent bit width field, the first exponent field, and the first mantissa field, where the normalized data includes a second sign field, a second exponent field, and a second mantissa field in a scientific notation method.

In a possible implementation, the first floating point number is used for data storage or data transfer, the normalized data is used for being input to a computing unit to participate in corresponding computation, and the computing unit includes one or more of a scalar computing unit, a vector computing unit, a matrix computing unit, or a tensor computing unit.

In a possible implementation, the second processor 502 is configured to: obtain first data, where the first data is a second floating point number in a format different from that of the first floating point number, or the first data is an uncoded operation result, and the operation result includes a sign bit, an exponent, and a mantissa; and code the first sign field, the exponent bit width field, the first exponent field, and the first mantissa field according to a value represented by the first data to obtain the first floating point number.

It should be noted that, for specific functions of function units in the apparatus for processing a floating point number described in this embodiment of this application, refer to related descriptions of step S401 and step S402 in the method embodiment in FIG. 4, or refer to descriptions of the embodiments corresponding to FIG. 5 to FIG. 8. Details are not described herein again.

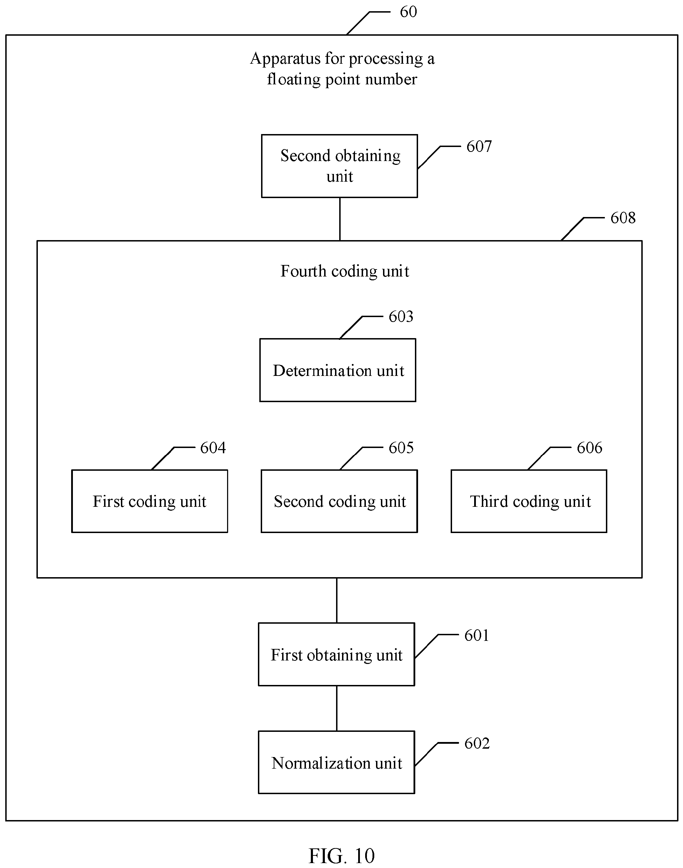

Further, refer to FIG. 10. FIG. 10 is a schematic diagram of a structure of another apparatus for processing a floating point number according to an embodiment of this application. As shown in FIG. 10, the apparatus for processing a floating point number 60 may include a first obtaining unit 601 and a normalization unit 602. Detailed descriptions of all the units are as follows:

The first obtaining unit 601 is configured to obtain a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number.

The normalization unit 602 is configured to obtain normalized data corresponding to the first floating point number based on the first sign field, the exponent bit width field, the first exponent field, and the first mantissa field, where the normalized data includes a second sign field, a second exponent field, and a second mantissa field in a scientific notation method.

In a possible implementation, the first floating point number is used for data storage or data transfer, the normalized data is used for being input to a computing unit to participate in corresponding computation, and the computing unit includes one or more of a scalar computing unit, a vector computing unit, a matrix computing unit, or a tensor computing unit.

In a possible implementation, the normalization unit 602 is specifically configured to: obtain, based on the first sign field, the second sign field in the normalized data; determine, based on the bit width D indicated by the exponent bit width field, the first exponent field and the first mantissa field from the first floating point number, and obtain, based on the first exponent field and the first mantissa field, the second exponent field and the second mantissa field in the normalized data.

In a possible implementation, a truth value corresponding to the normalized data satisfies the following formula:

$$X=(-1)^S \times 2^{Ei+Ec} \times (1+M)$$

X is a truth value corresponding to the normalized data; S is a value of the second sign field, the value of the second sign field is the same as that of the first sign field, and S is 0 or 1; Ei is a value of the second exponent field; Ec is a preset exponent center; and M is a value of the second mantissa field.

In a possible implementation, the apparatus further includes a determination unit 603, configured to: determine, based on the bit width D indicated by the exponent bit width field, a numerical range E corresponding to the first exponent field during coding, where Ei belongs to the numerical range E, and the numerical range E satisfies the following formula:

$$E=(-1)^{Se} \times [2^{D-1}, (2^D-1)]$$

Se is a sign bit of Ei, and Se is 0 or 1.

In a possible implementation, when D is equal to 0, Ei=0; when D is equal to 1, the value of the first exponent field is Es={Se}, and Ei={Se, 1'b1}; or when D is greater than 1, the value of the first exponent field is Es={Se, TF[2:D]}, and Ei={Se, 1'b1, TF[2:D]}, where TF is an amplitude of the Ei, 1'b1 is a most significant bit in the TF, 1'b1 does not occupy a bit width in the first exponent field, and a bit width of the second exponent field is D+1; TF[2:D] represents remaining bits in the TF except the most significant bit 1'b1, and a bit width occupied by the TF[2:D] in the first exponent field is D-1; and in the Ei, when D is greater than or equal to 1, a next bit of Se is the most significant bit 1'b1 of TF, and 1'b1 represents 1-bit binary data with a value of 1.

In a possible implementation, a coding manner of the exponent bit width field is integer coding; a bit width occupied by the exponent bit width field in the total bit width N is DW; the apparatus further includes a first coding unit 604: and the first coding unit 604 is configured to code, by using the integer coding, any value of 0 to $2^{DW}-1$ with the bit width DW occupied by the exponent bit width field, where the bit width D is 0 to $2^{DW}-1$.

In a possible implementation, a coding manner of the exponent bit width field is conventional prefix coding; a bit width occupied by the exponent bit width field in the total bit width N is DW1 or DW2, and DW1 is less than DW2; the apparatus further includes a second coding unit 605: and the second coding unit 605 is configured to code, by using the conventional prefix coding, any one of K1 values with the bit width DW1 occupied by the exponent bit width field, or any one of K2 values with the bit width DW2 occupied by the exponent bit width field, where a maximum value of the K1 values is less than a minimum value of the K2 values, and the bit width D belongs to the K1 values or the K2 values.

In a possible implementation, a coding manner of the exponent bit width field is unconventional prefix coding, a bit width occupied by the exponent bit width field in the total bit width N is DW1 or DW2, and DW1 is less than DW2; the apparatus further includes a third coding unit 606; and the third coding unit 606 is configured to: code, by using the unconventional prefix coding, any one of P1 values with the bit width DW1 occupied by the exponent bit width field, or any one of P2 values with the bit width DW2 occupied by the exponent bit width field, where a minimum value of the P1 values is greater than a maximum value of the P2 values, and the bit width D belongs to the P1 values or the P2 values.

In a possible implementation, when the first exponent field is all 1s and the first mantissa field is all 0s, the first sign field is 0 or 1, and the first floating point number is positive or negative 0; when the first exponent field is all 1s and the first mantissa field is not 0, the first sign field is 0 or 1, and the first floating point number is a subnormal value; when the Se of the first exponent field is 0, the TF is all 1s, and the first mantissa field is all 0s, the first sign field is 0 or 1, and the first floating point number is positive or negative infinity; or when the Se of the first exponent field is 0, the TF is all 1s, and the first mantissa field is not 0, the first sign field is 0 or 1, and the first floating point number is not a number NaN.

In a possible implementation, the apparatus further includes a second obtaining unit 607 and a fourth coding unit 608. The second obtaining unit 607 is configured to obtain first data, where the first data is a second floating point number in a format different from that of the first floating point number, or the first data is an uncoded operation result, and the operation result includes a sign bit, an exponent, and a mantissa.

The fourth coding unit 608 is configured to code the first sign field, the exponent bit width field, the first exponent field, and the first mantissa field according to a value represented by the first data to obtain the first floating point number.

It should be noted that, for specific functions of function units in the apparatus for processing a floating point number described in this embodiment of this application, refer to related descriptions of step S401 and step S402 in the method embodiment in FIG. 4, or refer to descriptions of the embodiments corresponding to FIG. 5 to FIG. 8. Details are not described herein again.

Each unit in FIG. 10 may be implemented by software, hardware, or a combination thereof. A unit implemented by hardware may include a logic circuit, an algorithm circuit, an analog circuit, or the like. A unit implemented by software may include program instructions, is considered as a software product stored in a memory, and may be run by a processor to implement a related function. For details, refer to the foregoing descriptions.

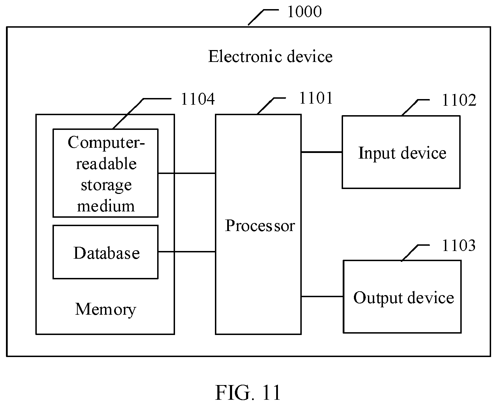

Based on the descriptions of the foregoing method and apparatus embodiments, an embodiment of this application further provides an electronic device. Refer to FIG. 11. FIG. 11 is a schematic diagram of a structure of an electronic device according to an embodiment of this application. As shown in FIG. 11, the electronic device 1000 includes at least a processor 1101, an input device 1102, an output device 1103, and a computer-readable storage medium 1104. The electronic device 10 may further include other general-purpose components. Details are not described herein again. The processor 1101, the input device 1102, the output device 1103, and the computer-readable storage medium 1104 in the electronic device 1000 may be connected by a bus or in another manner.

The processor 1101 may be a general-purpose central processing unit (CPU), a microprocessor, an application-specific integrated circuit (application-specific integrated circuit, ASIC), or one or more integrated circuits for controlling program execution for the foregoing solutions.

The memory in the electronic device 1000 may be, but is not limited to, a read-only memory (read-only memory, ROM) or another type of static storage device capable of storing static information and instructions, a random access memory (random access memory, RAM) or another type of dynamic storage device capable of storing information and instructions, an electrically erasable programmable read-only memory (Electrically Erasable Programmable Read-Only memory, EEPROM), a compact disc read-only memory (Compact Disc Read-Only Memory, CD-ROM) or another compact disc storage, an optical disc storage (including a compact disc, a laser disc, an optical disc, a digital versatile disc, a Blu-ray disc, and the like), a magnetic disk storage medium or another magnetic storage device, or any other medium that can be used to carry or store expected program code in an instruction or data structure form and can be accessed by a computer. The memory may exist independently, and is connected to the processor by the bus. The memory may alternatively be integrated with the processor.

The computer-readable storage medium 1104 may be stored in the memory of the electronic device 1000, the computer-readable storage medium 1104 is configured to store a computer program, the computer program includes program instructions, and the processor 1101 is configured to execute the program instructions stored in the computer-readable storage medium 1104. The processor 1101 (or referred to as a CPU (Central Processing Unit, central processing unit)) is a computing core and a control core of the electronic device 1000, is suitable for implementing one or more instructions, and is specifically suitable for loading and executing one or more instructions to implement a corresponding method flow or a corresponding function. In an embodiment, the processor 1101 in this embodiment of this application may be configured to perform a series of processing of the method for processing a floating point number, including: obtaining a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number; and obtaining normalized data corresponding to the first floating point number based on the first sign field, the exponent bit width field, the first exponent field, and the first mantissa field, where the normalized data includes a second sign field, a second exponent field, and a second mantissa field in a scientific notation method, and the like.

It should be noted that for a function of each function unit of the electronic device 1000 described in this embodiment of this application, reference may be made to the related descriptions of the embodiments shown in FIG. 4 to FIG. 10. Details are not described herein again.

An embodiment of this application further provides a computer-readable storage medium. The computer-readable storage medium may store a program. When the program is executed by a processor, the processor is enabled to perform some or all of the steps of any one of the foregoing method embodiments.

An embodiment of this application further provides a computer program. The computer program includes instructions. When the computer program is executed by a multi-core processor, the processor is enabled to perform some or all of the steps of any one of the foregoing method embodiments.

In the foregoing embodiments, the description of each embodiment has respective focuses. For a part that is not described in detail in an embodiment, reference may be made to related descriptions in other embodiments. It should be noted that, for brief description, the foregoing method embodiments are represented as a series of actions. However, persons skilled in the art should appreciate that this application is not limited to the described order of the actions, because according to this application, some steps may be performed in another order or simultaneously. It should be further appreciated by a person skilled in the art that embodiments described in this specification all belong to preferred embodiments, and the involved actions and modules are not necessarily required by this application.

In the several embodiments provided in this application, it should be understood that the disclosed apparatus may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic or other forms.

The foregoing units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, function units in embodiments of this application may be integrated into one processing unit, or each of the units may exist alone physically, or two or more units are integrated into one unit. The integrated unit may be implemented in a form of hardware, or may be implemented in a form of a software function unit.

When the foregoing integrated unit is implemented in the form of a software function unit and sold or used as an independent product, the integrated unit may be stored in a computer-readable storage medium. Based on such an understanding, the technical solutions of this application essentially, or the part contributing to the prior art, or all or some of the technical solutions may be implemented in the form of a software product. The software product is stored in a storage medium and includes several instructions for instructing a computer device (which may be a personal computer, a server, or a network device) to perform all or some of the steps of the methods described in embodiments of this application. The foregoing storage medium may include: any medium that can store program code, such as a USB flash drive, a removable hard disk, a magnetic disk, an optical disk, a read-only memory (read-only memory, ROM), a double data rate synchronous dynamic random access memory (double data rate, DDR), a flash (flash), or a random access memory (random access memory, RAM).

The foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

**Claims**

1.  A method for processing a floating point number, comprising:

    obtaining a first floating point number, wherein the first floating point number comprises a first sign field, an exponent bit width field, a first exponent field, and a first mantissa field, and the exponent bit width field is used for indicating a bit width D occupied by the first exponent field in a total bit width N of the first floating point number; and
    obtaining normalized data corresponding to the first floating point number based on the first sign field, the exponent bit width field, the first exponent field, and the first mantissa field, wherein the normalized data comprises a second sign field, a second exponent field, and a second mantissa field.

2.  The method according to claim 1, wherein the first floating point number is used for data storage or data transfer; the normalized data is used for being input to a computing unit to participate in corresponding computation, and the computing unit comprises one or more of a scalar computing unit, a vector computing unit, a matrix computing unit, or a tensor computing unit.

3. The method according to claim 1 or 2, wherein the obtaining normalized data corresponding to the first floating point number based on the first sign field, the exponent bit width field, the first exponent field, and the first mantissa field comprises:

> obtaining, based on the first sign field, the second sign field in the normalized data; and
> determining, based on the bit width D indicated by the exponent bit width field, the first exponent field and the first mantissa field from the first floating point number, and obtaining, based on the first exponent field and the first mantissa field, the second exponent field and the second mantissa field in the normalized data.

4. The method according to claim 3, wherein a truth value corresponding to the normalized data satisfies the following formula:

$$X=(-1)^S \times 2^{Ei+Ec} \times (1+M),$$

wherein

X is a truth value corresponding to the normalized data; S is a value of the second sign field, the value of the second sign field is the same as that of the first sign field, and S is 0 or 1; Ei is a value of the second exponent field; Ec is a preset exponent center; and M is a value of the second mantissa field.

5. The method according to claim 4, wherein the method further comprises:
determining, based on the bit width D indicated by the exponent bit width field, a numerical range E corresponding to the first exponent field during coding, wherein Ei belongs to the numerical range E, and the numerical range E satisfies the following formula:

$$E=(-1)^{Se} \times [2^{D-1}, (2^D-1)],$$

wherein
Se is a sign bit of Ei, and Se is 0 or 1.

6. The method according to claim 5, wherein

> when D is equal to 0, Ei=0;
> when D is equal to 1, the value of the first exponent field is Es={Se}, and Ei={Se, 1'b1};
> when D is greater than 1, the value of the first exponent field is Es={Se, TF[2:D]}, and Ei={Se, 1'b1, TF[2:D]}, wherein
> TF is an amplitude of the Ei, 1'b1 is a most significant bit in the TF, 1'b1 does not occupy a bit width in the first exponent field, and a bit width of the second exponent field is D+1; TF[2:D] represents remaining bits in the TF except the most significant bit 1'b1, and a bit width occupied by the TF[2:D] in the first exponent field is D-1; and in the Ei, when D is greater than or equal to 1, a next bit of Se is the most significant bit 1'b1 of TF, and 1'b1 represents 1-bit binary data with a value of 1.

7. The method according to any one of claims 1 to 6, wherein a coding manner of the exponent bit width field is integer coding; a bit width occupied by the exponent bit width field in the total bit width N is DW; and the method further comprises:
coding, by using the integer coding, any value of 0 to $2^{DW}$-1 with the bit width DW occupied by the exponent bit width field, wherein the bit width D is 0 to $2^{DW}$-1.

8. An apparatus for processing a floating point number, wherein the apparatus comprises a first processor configured to:

> obtain a first floating point number, wherein the first floating point number comprises a first sign field, an exponent bit width field, a first exponent field, and a first mantissa field, and the exponent bit width field is used for indicating a bit width D occupied by the first exponent field in a total bit width N of the first floating point number; and
> obtain normalized data corresponding to the first floating point number based on the first sign field, the exponent bit width field, the first exponent field, and the first mantissa field, wherein the normalized data comprises a second sign field, a second exponent field, and a second mantissa field.

9. The apparatus according to claim 8, wherein the first floating point number is used for data storage or data transfer, the normalized data is used for being input to a computing unit to participate in corresponding computation, and the computing unit comprises one or more of a scalar computing unit, a vector computing unit, a matrix computing unit, or a tensor computing unit.

10. The apparatus according to claim 8 or 9, wherein the first processor is specifically configured to:

obtain, based on the first sign field, the second sign field in the normalized data; and
determine, based on the bit width D indicated by the exponent bit width field, the first exponent field and the first mantissa field from the first floating point number, and obtain, based on the first exponent field and the first mantissa field, the second exponent field and the second mantissa field in the normalized data.

11. The apparatus according to claim 10, wherein a truth value corresponding to the normalized data satisfies the following formula:

$$X = (-1)^S \times 2^{Ei+Ec} \times (1+M),$$

wherein
X is a truth value corresponding to the normalized data; S is a value of the second sign field, the value of the second sign field is the same as that of the first sign field, and S is 0 or 1; Ei is a value of the second exponent field; Ec is a preset exponent center; and M is a value of the second mantissa field.

12. The apparatus according to claim 11, wherein the apparatus further comprises a second processor, the second processor configured to:

determine, based on the bit width D indicated by the exponent bit width field, a numerical range E corresponding to the first exponent field during coding, wherein Ei belongs to the numerical range E, and the numerical range E satisfies the following formula:

$$E = (-1)^{Se} \times [2^{D-1}, (2^D - 1)],$$

wherein Se is a sign bit of Ei, and Se is 0 or 1.

13. The apparatus according to claim 12, wherein

when D is equal to 0, Ei=0;
when D is equal to 1, the value of the first exponent field is Es={Se}, and Ei={Se, 1'b1}; and
when D is greater than 1, the value of the first exponent field is Es={Se, TF[2:D]}, and Ei={Se, 1'b1, TF[2:D]}, wherein
TF is an amplitude of the Ei, 1'b1 is a most significant bit in the TF, 1'b1 does not occupy a bit width in the first exponent field, and a bit width of the second exponent field is D+1; TF[2:D] represents remaining bits in the TF except the most significant bit 1'b1, and a bit width occupied by the TF[2:D] in the first exponent field is D-1; and in the Ei, when D is greater than or equal to 1, a next bit of Se is the most significant bit 1'b1 of TF, and 1'b1 represents 1-bit binary data with a value of 1.

14. The apparatus according to any one of claims 8 to 13, wherein a coding manner of the exponent bit width field is integer coding; a bit width occupied by the exponent bit width field in the total bit width N is DW; and the method further comprises:
code, by using the integer coding, any value of 0 to $2^{DW}-1$ with the bit width DW occupied by the exponent bit width field, wherein the bit width D is 0 to $2^{DW}-1$.

15. A computer-readable storage medium, wherein the computer-readable storage medium stores a computer program, and when the computer program is executed by a computer or a processor, the method according to any one of claims 1 to 7 is implemented.

16. A computer program, wherein the computer program comprises instructions, and when the computer program is executed by a computer or a processor, the computer or the processor is enabled to perform the method according to any one of claims 1 to 7.

FIG. 1

| HiFloat (floating point) decoder (decoder) [100] | | | |
|---|---|---|---|
| Sign (sign): 1 bit | Dot: DW bits (D) | Exponent (exponent): D bits | Mantissa (mantissa): (N–1–DW–D) bits |
| S | {E,M}=MUX (D) | | |

Computing unit [400]

**FIG. 2**

| Computing unit [400] | | | |
|---|---|---|---|

Exponent (exponent)    Mantissa (mantissa)

D=Leading One Detect (Abs(E))Shift mantissa and round, update M, E, and D (Leading one detect on absolute value of exponent, mantissa shift and round, update M, E, and D)

S    D    E    M

| Sign (sign): 1 bit | Dot: DW bits (D) | Exponent (exponent): D bits | Mantissa (mantissa): (N–1–DW–D) bits |
|---|---|---|---|

**HiFloat (floating point) encoder (encoder) [200]**

**FIG. 3**

Obtain a first floating point number, where the first floating point number includes a first sign field, an exponent bit width field, a first exponent field, and a first mantissa field, and the exponent bit width field is used for indicating a bit width D occupied by the first exponent field in a total bit width N of the first floating point number

S401

Obtain normalized data corresponding to the first floating point number based on the first sign field, the exponent bit width field, the first exponent field, and the first mantissa field, where the normalized data includes a second sign field, a second exponent field, and a second mantissa field

S402

FIG. 4

FIG. 5

FIG. 6

FIG. 7

FIG. 8

FIG. 9

60

**Apparatus for processing a
floating point number**

Second obtaining
unit — 607

— 608

Fourth coding unit

— 603

Determination unit

— 604

First coding unit

— 605

Second coding unit

— 606

Third coding unit

First obtaining unit — 601

Normalization unit — 602

FIG. 10

1000

Electronic device

1104

1101

1102

Computer-readable storage medium

Processor

Input device

Database

Memory

1103

Output device

FIG. 11

Europäisches
Patentamt

European
Patent Office

Office européen
des brevets

# EUROPEAN SEARCH REPORT

**Application Number**

EP 23 16 3966

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/285468 A1 (BOCCO ANDREA [FR] ET AL) 10 September 2020 (2020-09-10) * figures 2, 7, 11-14 * * paragraphs [0048] - [0060], [0089], [0110] - [0111] * ----- | 1-16 | INV. G06F7/483 H03M7/24 |
| A | US 2019/042243 A1 (TANG PING TAK [US]) 7 February 2019 (2019-02-07) * the whole document * ----- | 1-16 | |

**TECHNICAL FIELDS SEARCHED (IPC)**

G06F
H03M

The present search report has been drawn up for all claims

| Place of search | Date of completion of the search | Examiner |
|---|---|---|
| Munich | 20 July 2023 | Winkelbauer, Andreas |

EPO FORM 1503 03.82 (P04C01)

## ANNEX TO THE EUROPEAN SEARCH REPORT
## ON EUROPEAN PATENT APPLICATION NO.

EP 23 16 3966

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2023

| Patent document cited in search report | | Publication date | Patent family member(s) | | Publication date |
|---|---|---|---|---|---|
| US 2020285468 | A1 | 10-09-2020 | EP | 3706004 A1 | 09-09-2020 |
| | | | FR | 3093571 A1 | 11-09-2020 |
| | | | US | 2020285468 A1 | 10-09-2020 |
| US 2019042243 | A1 | 07-02-2019 | CN | 110457067 A | 15-11-2019 |
| | | | EP | 3567472 A1 | 13-11-2019 |
| | | | US | 2019042243 A1 | 07-02-2019 |

EPO FORM P0459

For more details about this annex : see Official Journal of the European Patent Office, No. 12/82